# EUROPEAN PATENT APPLICATION

(11) **EP 1 777 758 A1**
(43) Date of publication of application: **25.04.2007**
(21) Application number: 06018565.9
(22) Date of filing: 05.09.2006
(51) Int. Cl.: H01L 51/50

(54) **Organic light emitting device**

(30) Priority: 18.10.2005 JP 2005303475
(71) Applicant: SEMICONDUCTOR ENERGY LABORATORY CO., LTD., Atsugi-shi, Kanagawa-ken 243-0036 (JP)
(72) Inventor: Kawakami, Takahiro Semicond. Energy Lab. Co.,Ltd., Kanagawa-ken, 243-0036 (JP); Sakata, Junichiro Semicond. Energy Lab. Co.,Ltd., Kanagawa-ken, 243-0036 (JP); Ikeda, Hisao Semicond. Energy Lab. Co.,Ltd., Kanagawa-ken, 243-0036 (JP); Aoyama, Tomoya Semicond. Energy Lab. Co.,Ltd., Kanagawa-ken, 243-0036 (JP)
(74) Representative: Grünecker, Kinkeldey, Stockmair & Schwanhäusser Anwaltssozietät

(57) **Abstract**

To provide a light emitting element driven at a low voltage, and a light emitting element and an electronic apparatus with low power consumption. The invention provides a light emitting element in which a light emitting layer containing a light emitting substance and a layer containing bathophenanthroline are provided between a first electrode and a second electrode. The light emitting substance emits light when a voltage is applied so that the potential of the first electrode is higher than that of the second electrode. An alkali metal or an alkaline earth metal is not doped in the layer containing bathophenanthroline

## Description

### BACKGROUND OF THE INVENTION

### 1. Field of the Invention

The present invention relates to a current excitation light emitting element, and a light emitting device and an electronic apparatus each including a light emitting element.

### 2. Description of the Related Art

In recent years, research and development for light emitting elements using light emitting organic compounds have been actively pursued. A basic structure of these light emitting elements is such that a layer including a light emitting organic compound is interposed between a pair of electrodes. When voltage is applied to such an element, electrons and holes are injected from the pair of electrodes into the layer including a light emitting organic compound, and current flows. Then, by those carriers (electrons and holes) being recombined, the light emitting organic compound forms an excited state, and light is emitted when the excited state returns to a ground state. Due to such mechanism, such a light emitting element is called a current excitation light emitting element.

Note that as types of excitation states which an organic compound forms, a singlet excited state and a triplet excited state are possible. Light emission from a singlet excited state is called fluorescence, and light emission from a triplet excited state is called phosphorescence.

Since such a light emitting element is formed of an organic thin film with a thickness of, for example, about 0.1 µm, there is a great advantage that it can be manufactured to be thin and light weight. Furthermore, since the time it takes from carrier injection to light emission is about 1 µs or less, another feature is that the response speed is extremely fast. It is thought that these features are suitable for flat panel displays.

In addition, since these light emitting elements are formed in film forms, planar light emission can be easily obtained by forming a large-area element. This is a feature that is difficult to obtain by a point light source typified by incandescent lamps and LEDs, or by a line light source typified by fluorescent lights. Accordingly, utility value as a surface light source that can be applied to illumination and the like is also high.

In display devices incorporated in various kinds of information processing apparatuses that have been rapidly developed in recent years, low power consumption is highly demanded in particular, and a low driving voltage of light emitting elements has been attempted in order to achieve this.

### SUMMARY OF THE INVENTION

In view of the foregoing problems, the invention provides a light emitting element with a low driving voltage. The invention also provides a light emitting device and an electronic apparatus with low power consumption.

One mode of the invention is a light emitting element in which a light emitting layer containing a light emitting substance and a layer containing bathophenanthroline are provided between a first electrode and a second electrode. The layer containing bathophenanthroline is provided on the second electrode side of the light emitting layer, and the light emitting substance emits light when voltage is applied so that the potential of the first electrode is higher than that of the second electrode. In the structure, an alkali metal or an alkaline earth metal is not doped in the layer containing bathophenanthroline.

In the aforementioned structure, a layer containing an alkali metal compound or an alkaline earth metal compound is preferably provided between the layer containing bathophenanthroline and the second electrode.

In the aforementioned structure, the layer containing an alkali metal compound or an alkaline earth metal compound is preferably a layer containing one or more of lithium fluoride, cesium fluoride, and calcium fluoride.

One mode of the invention is a light emitting element in which a layer containing a composite material of an organic compound and an inorganic compound, a light emitting layer containing a light emitting substance, and a layer containing bathophenanthroline are provided between a pair of electrodes.

One mode of the invention is a light emitting element in which a layer containing a composite material of an organic compound and an inorganic compound, a light emitting layer containing a light emitting substance, and a layer containing bathophenanthroline are provided between a first electrode and a second electrode. The layer containing a composite material is provided so as to be in contact with the first electrode, the layer containing bathophenanthroline is provided on the second electrode side of the light emitting layer, and the light emitting substance emits light when voltage is applied so that the potential of the first electrode is higher than that of the second electrode.

In the aforementioned structure, a layer containing an alkali metal compound or an alkaline earth metal compound is preferably provided between the layer containing bathophenanthroline and the second electrode.

In the aforementioned structure, the layer containing an alkali metal compound or an alkaline earth metal compound is preferably a layer containing one or more of lithium fluoride, cesium fluoride, and calcium fluoride.

In the aforementioned structure, it is preferable to use an aromatic amine compound, a carbazole derivative, or aromatic hydrocarbon as the organic compound.

In the aforementioned structure, the inorganic compound preferably exhibits electron accepting properties with respect to the organic compound.

In the aforementioned structure, the inorganic compound is preferably a transition metal oxide.

In the aforementioned structure, the inorganic compound is preferably an oxide of a metal belonging to any of groups 4 to 8 of the periodic table.

More preferably, the inorganic compound is any of vanadium oxide, niobium oxide, tantalum oxide, chromium oxide, molybdenum oxide, tungsten oxide, manganese oxide, and rhenium oxide.

In the aforementioned structure, the layer containing bathophenanthroline is preferably 10 to 100 nm in thickness, and more preferably, 30 to 60 nm in thickness.

A light emitting device of the invention includes the aforementioned light emitting element and a control means for controlling light emission of the light emitting element. The light emitting device in this specification refers to an image display device, a light emitting device, or a light source (including an illuminating device). Furthermore, the light emitting device also refers to a module in which a panel is attached to a connector such as an FPC (Flexible Printed Circuit), a TAB (Tape Automated Bonding) tape, or a TCP (Tape Carrier Package), a module in which a printed wiring board is attached to the end of a TAB tape or a TCP, and a module in which an IC (Integrated Circuit) is directly mounted on a light emitting element by COG (Chip On Glass).

In addition, the scope of the invention includes an electronic apparatus in which the light emitting element of the invention is used for a display portion. Accordingly, the electronic apparatus of the invention includes a display portion that has the aforementioned light emitting element and a control means for controlling light emission of the light emitting element.

The light emitting element of the invention includes a layer containing bathophenanthroline, and can be driven at a low voltage.

When a layer containing a composite material is provided in addition to the layer containing bathophenanthroline, the light emitting element of the invention can be driven at a lower voltage.

When a light emitting element with a low driving voltage is used, a light emitting device and an electronic apparatus with lower power consumption can be obtained.

### BRIEF DESCRIPTION OF DRAWINGS

FIGS. 1A to 1C each show a light emitting element of the invention.
FIG 2 shows a light emitting element of the invention.
FIGS. 3A and 3B each show a light emitting device of the invention.
FIG. 4 shows a light emitting device of the invention.
FIGS. 5A to 5D each show an electronic apparatus of the invention.
FIG 6 shows an electronic apparatus of the invention.
FIG 7 shows a light emitting element of the invention.
FIG 8 shows the current-voltage characteristics of light emitting elements of Embodiment 1 and the comparative example 1.
FIG 9 shows the current-voltage characteristics of light emitting elements of Embodiment 2 and Embodiment 3.
FIG 10 shows the luminance-voltage characteristics of light emitting elements of Embodiment 4 and the comparative example 2.
FIG 11 shows the current-voltage characteristics of the light emitting elements of Embodiment 4 and the comparative example 2.
FIG 12 shows the luminance-voltage characteristics of light emitting elements of Embodiment 5 and the comparative example 3.
FIG 13 shows the current-voltage characteristics of the light emitting elements of Embodiment 5 and the comparative example 3.
FIG 14 shows the luminance-voltage characteristics of light emitting element of Embodiment 6 and the comparative example 4.
FIG 15 shows the current-voltage characteristics of the light emitting elements of Embodiment 6 and the comparative example 4.
FIG 16 shows normalized time-varying luminance of light emitting elements of Embodiment 7 and the comparative example 5.
FIG 17 shows time-varying voltage of the light emitting elements of the light emitting elements of Embodiment 7 and the comparative example 5.
FIG 18 shows normalized time-varying luminance of light emitting elements of Embodiment 8 and the comparative example 6.
FIG 19 shows time-varying voltage of the light emitting elements of Embodiment 8 and the comparative example 6.
FIG 20 shows a light emitting element of embodiments.
FIG 21 shows a light emitting element of embodiments.
FIG 22 shows a light emitting element of embodiments.
FIGS. 23A and 23B each show a ¹H-NMR chart of 9-[4-(*N*-phenylamino)phenyl]carbazole.
FIGS. 24A and 24B each show a ¹H-NMR chart of 9-(4-{*N*-[4-(9-carbazolyl)phenyl]-*N*-phenylamino}phenyl)-10-phenylanthracene.
FIG. 25 shows the absorption spectrum of 9-(4-{*N*-[4-(9-carbazolyl)phenyl]-*N*-phenylamino}phenyl)-10-phenylanthracene.
FIG 26 shows the light emission spectrum of 9-(4-{*N*-[4-(9-carbazolyl)phenyl]-*N*-phenylamino}phenyl)-10-phenylanthracene.
FIGS. 27A and 27B each show a ¹H-NMR chart of 9-[4-(*N*-carbazolyl)]phenyl-10-phenylanthracene.
FIG 28 shows the light emission spectrum of 9-[4-(*N*-carbazolyl)]phenyl-10-phenylanthracene.
FIGS. 29A and 29B each show the microscopic observation results of the light emitting element of Embodiment 9.
FIGS. 30A and 30B each show the microscopic observation results of the light emitting element of the comparative example 7.

### DETAILED DESCRIPTION OF THE INVENTION

Although the invention will be described by way of embodiment modes and embodiments with reference to the accompanying drawings, it is to be understood that various changes and modifications will be apparent to those skilled in the art. Therefore, unless such changes and modifications depart from the scope of the invention, they should be construed as being included therein.

### [Embodiment Mode 1]

A light emitting element of the invention includes a plurality of layers interposed between a pair of electrodes. The plurality of layers are stacked by combining a layer made of a substance with high carrier injection properties and a layer made of a substance with high carrier transporting properties so that a light emitting region is formed apart from the electrodes, namely, so that carriers are recombined in a portion apart from the electrodes.

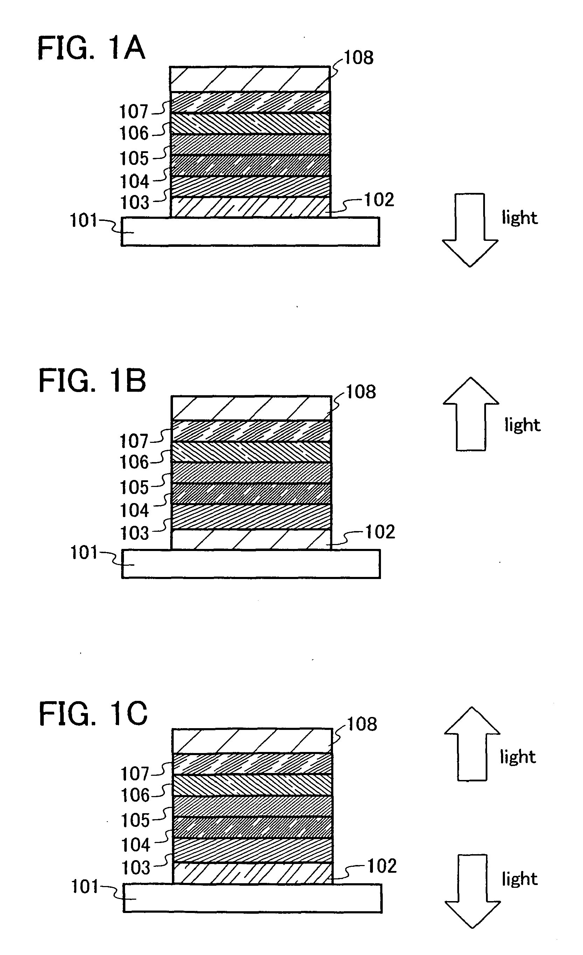

One mode of the light emitting element of the invention is described below with reference to FIG. 1A.

In the light emitting element according to this embodiment mode, a first electrode 102 is formed over a substrate 101, and a first layer 103, a second layer 104, a third layer 105, a fourth layer 106, a fifth layer 107, and a second electrode 108 are stacked in this order over the first electrode 102. Note that in this embodiment mode, the first electrode 102 functions as an anode while the second electrode 108 functions as a cathode.

The substrate 101 is used as a support of the light emitting element. The substrate 101 can be made of, for example, glass, plastic, or the like. Other materials may also be used as long as the substrate 101 can serve as a support in a manufacturing process of the light emitting element.

The first electrode 102 is preferably made of a metal, an alloy, a conductive compound, a mixture of these, or the like, each having a high work function (specifically, a work function of 4.0 eV or higher). Specifically, indium oxide-tin oxide (ITO: Indium Tin Oxide), indium oxide-tin oxide containing silicon or silicon oxide, indium oxide-zinc oxide (IZO: Indium Zinc Oxide), indium oxide containing tungsten oxide and zinc oxide (IWZO), or the like can be used. These conductive metal oxide films are generally formed by sputtering. For example, indium oxide-zinc oxide (IZO) can be formed by sputtering using a target in which 1 to 20 wt% of zinc oxide is added to indium oxide. Indium oxide containing tungsten oxide and zinc oxide (IWZO) can be formed by sputtering using a target in which 0.5 to 5 wt% of tungsten oxide and 0.1 to 1 wt% of zinc oxide are mixed with indium oxide. Alternatively, the conductive metal oxide films may be formed by applying a sol-gel method. Further, gold (Au), platinum (Pt), nickel (Ni), tungsten (W), chromium (Cr), molybdenum (Mo), iron (Fe), cobalt (Co), copper (Cu), palladium (Pd), a metal nitride (such as titanium nitride: TiN), or the like can also be used.

The first layer 103 is a layer containing a substance with high hole injection properties. The first layer 103 can be made of molybdenum oxide (MoOₓ), vanadium oxide (VOₓ), ruthenium oxide (RuOₓ), tungsten oxide (WOₓ), manganese oxide (MnOₓ), or the like. Alternatively, the first layer 103 may be formed of a phthalocyanine-based compound such as phthalocyanine (abbreviation: H₂Pc) and copper phthalocyanine (CuPc), a polymer such as poly(ethylenedioxythiophene)/poly(styrene sulfonate) (PEDOT/PSS), or the like.

The second layer 104 is a layer containing a substance with high hole transporting properties. The substance with high hole transporting properties may be, for example, an aromatic amine compound (that is, a compound having a benzene ring-nitrogen bond) such as 4,4'-bis[*N*-(1-naphthyl)-*N*-phenylamino]biphenyl (abbreviation: NPD or α-NPD), *N*,*N*-diphenyl-*N*,*N*-bis(3-methylphenyl)-1,1-biphenyl-4,4-diamine (abbreviation: TPD), 4,4',4"-tris(*N*,*N*-diphenylamino)triphenylamine (abbreviation: TDATA), 4,4',4"-tris[*N*-(3-methylphenyl)-*N*-phenylamino]triphenylamine (abbreviation: MTDATA), and 4, 4'-bis[*N*-phenyl-*N*-(spirofluorene-2-yl)]biphenyl (abbreviation: BSPB). These substances mainly are substances each having a hole mobility of 10⁻⁶ cm²/Vs or higher. However, other substances than these may also be used as long as the hole transporting properties thereof are higher than the electron transporting properties. Note that the layer containing a substance with high hole transporting properties is not limited to a single layer, and two or more layers containing the aforementioned substances may be stacked.

The third layer 105 is a layer containing a substance with high light emitting properties, and can be made of various kinds of materials. For example, a substance with high light emitting properties is freely combined with a substance with high carrier transporting properties and good film quality (that is, a substance difficult to be crystallized), such as tris(8-quinolinolato)aluminum (abbreviation: Alq), 9,10-di(2-naphthyl)anthracene (abbreviation: DNA), and 4,4'-bis[*N*-(1-naphthyl)-*N*-phenylamino]biphenyl (abbreviation: NPB). Specifically, the substance with high light emitting properties may be a singlet light emitting material (fluorescent material) such as *N*,*N*'-dimethylquinacridone (abbreviation: DMQd), *N*,*N*'-diphenylquinacridone (abbreviation: DPQd), 3-(2-benzothiazoyl)-7-diethylamino coumarin (abbreviation: coumarin 6), 4-(dicyanomethylene)-2-methyl-6-(*p*-dimethylaminostyryl)-4*H*-pyran (abbreviation: DCM1), 4-(dicyanomethylene)-2-methyl-6-(julolidine-4-yl-vinyl)-4*H*-pyran (abbreviation: DCM2), 9,10-diphenylanthracene, 5,12-diphenyltetracene (abbreviation: DPT), perylene, and rubrene, or a triplet light emitting material (phosphorescent material) such as bis(2-(2'-benzothienyl)pyridinato-*N,C*^{3'})(acetylacetonate)iridium (abbreviation: Ir(btp)₂(acac)). Note that since Alq and DNA are substances with high light emitting properties, the third layer 105 may be formed of only one of these substances.

The fourth layer 106 is a layer containing bathophenanthroline (4,7-Diphenyl-1,10-phenanthroline, abbreviation: BPhen) represented by the structural formula (1). Bathophenanthroline has superior electron transporting properties, and thus the fourth layer 106 made of bathophenanthroline allows the driving voltage of the light emitting element to be reduced.

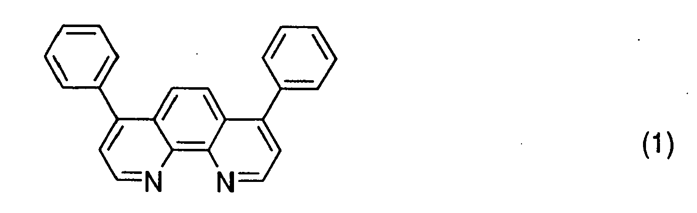

The thickness of the fourth layer 106 is preferably 10 to 100 nm, and more preferably 30 to 60 nm.

A layer containing a substance with high electron transporting properties may be provided between the third layer 105 and the fourth layer 106. The substance with high electron transporting properties is, for example, a metal complex having a quinoline skeleton or a benzoquinoline skeleton, such as tris(8-quinolinolato)aluminum (abbreviation: Alq), tris(5-methyl-8-quinolinolato)aluminum (abbreviation: Almq₃), bis(10-hydroxybenzo[*h*]-quinolinato)beryllium (abbreviation: BeBq₂), and bis(2-methyl-8-quinolinolato)-4-phenylphenolato-aluminum (abbreviation: BAlq). Alternatively, a metal complex having oxazole ligand or thiazole ligand, such as bis[2-(2-hydroxyphenyl)-benzoxazolato]zinc (abbreviation: Zn(BOX)₂) and bis[2-(2-hydroxyphenyl)-benzothiazolato]zinc (abbreviation: Zn(BTZ)₂) can be used. Besides the metal complexes, 2-(4-biphenylyl)-5-(4-*tert*-butylphenyl)-1,3,4-oxadiazole (abbreviation: PBD), 1,3-bis[5-(*p*-*tert*-butylphenyl)-1,3,4-oxadiazole-2-yl]benzene (abbreviation: OXD-7), 3-(4-*tert*-butylphenyl)-4-phenyl-5-(4-biphenylyl)-1,2,4-triazole (abbreviation: TAZ), 3-(4-*tert*-butylphenyl)-4-(4-ethylphenyl)-5-(4-biphenylyl)-1,2,4-triazole (abbreviation: p-EtTAZ), bathocuproin (abbreviation: BCP), or the like can also be used. The substances mentioned here mainly are substances each having an electron mobility of 10⁻⁶ cm²/Vs or higher. Note that the layer containing a substance with high electron transporting properties may be formed of other substances than those described above as long as the substances have higher electron transporting properties than hole transporting properties. Furthermore, the layer containing a substance with high electron transporting properties is not limited to a single layer, and two or more layers made of the aforementioned substances may be stacked.

The fifth layer 107 is a layer having a function of promoting electron injection. The layer having a function of promoting electron injection can be made of an alkali metal compound or an alkaline earth metal compound such as lithium fluoride (LiF), lithium oxide (Li₂O), cesium fluoride (CsF), magnesium fluoride (MgF₂), calcium fluoride (CaF₂), and barium fluoride (BaF₂). It is preferable to use LiF, since it is a nonhygroscopic compound. Alternatively, the fifth layer 107 may be made of a layer containing a substance with electron transporting properties which is mixed with an alkali metal or an alkaline earth metal. As the substance with electron transporting properties, the aforementioned substances with high electron transporting properties can be used. For example, the layer having a function of promoting electron injection can be made of Alq mixed with magnesium (Mg) or lithium (Li), bathophenanthroline mixed with magnesium (Mg) or lithium (Li), or the like.

The second electrode 108 can be made of a metal, an alloy, a conductive compound, a mixture of these, or the like, each having a low work function (a work function of 3.8 eV or lower). Specifically, an element belonging to group 1 or 2 of the periodic table, that is, an alkali metal such as lithium (Li) and cesium (Cs), an alkaline earth metal such as magnesium (Mg), calcium (Ca), and strontium (Sr), or an alloy containing these (MgAg, AlLi) can be used as a cathode material. Note that if a layer containing a substance with electron transporting properties is mixed with an alkali metal or an alkaline earth metal to be used as the fifth layer 107, various kinds of conductive materials such as Al, Ag, ITO, and ITO containing silicon can be used for the second electrode 108 regardless of the work function.

The first layer 103, the second layer 104, the third layer 105, the fourth layer 106, and the fifth layer 107 can be formed by various kinds of methods. For example, they may be formed by evaporation, ink jet printing, spin coating, or the like. In addition, each electrode and each layer may be formed by different methods.

In the light emitting element of the invention having such a structure as described above, when current flows due to a potential difference between the first electrode 102 and the second electrode 108, holes and electrons are recombined in the third layer 105 that contains a substance with high light emitting properties, and thus light is emitted. That is to say, a light emitting region is formed in the third layer 105. However, the entire third layer 105 does not necessarily serve as the light emitting region. For example, the light emitting region may be formed in a part of the third layer 105 only at the second layer 104 side or the fourth layer 106 side.

Light is emitted to the outside through one or both of the first electrode 102 and the second electrode 108. Accordingly, one or both of the first electrode 102 and the second electrode 108 are made of a light transmissive substance. If only the first electrode 102 is made of a light transmissive substance, light is emitted to the substrate side through the first electrode 102 as shown in FIG 1A. Meanwhile, if only the second electrode 108 is made of a light transmissive substance, light is emitted to the opposite side of the substrate through the second electrode 108 as shown in FIG 1B. If the first electrode 102 and the second electrode 108 are both made of a light transmissive substance, light is emitted to both the substrate side and the opposite side of the substrate through the first electrode 102 and the second electrode 108 as shown in FIG 1C.

The structure of the layers provided between the first electrode 102 and the second electrode 108 is not limited to the aforementioned one. Another structure may also be adopted as long as it has a region where holes and electrons are recombined at a portion apart from the first electrode 102 and the second electrode 108 so as to prevent optical quenching caused by the proximity of the light emitting region and metal, and the fourth layer contains bathophenanthroline.

That is to say, the stacked structure of layers is not particularly limited, and layers made of a substance with high electron transporting properties or high hole transporting properties, a substance with high electron injection properties, a substance with high hole injection properties, a substance with bipolar properties (a substance having high electron transporting properties and high hole transporting properties), and the like, may be freely combined with a layer containing bathophenanthroline.

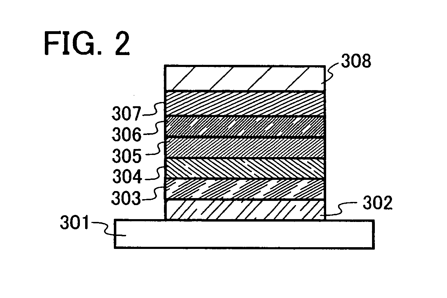

A light emitting element shown in FIG 2 has a structure in which a first layer 303 having a function of promoting electron injection, a second layer 304 containing a substance with high electron transporting properties, a third layer 305 containing a substance with high light emitting properties, a fourth layer 306 containing a substance with high hole transporting properties, a fifth layer 307 containing a composite material of an organic compound and an inorganic compound, and a second electrode 308 functioning as an anode are stacked in this order over a first electrode 302 functioning as a cathode. Note that reference numeral 301 denotes a substrate.

In this embodiment mode, the light emitting element is manufactured over a substrate made of glass, plastic, or the like. When a plurality of such light emitting elements are manufactured over one substrate, a passive light emitting device can be obtained. Alternatively, for example, a thin film transistor (TFT) may be formed over a substrate made of glass, plastic, or the like, and a light emitting element may be manufactured over an electrode that is electrically connected to the TFT. This allows to manufacture an active matrix light emitting device in which the driving of a light emitting element is controlled by a TFT. Note that the structure of a TFT is not particularly limited, and either a staggered TFT or a inversely staggered TFT may be used. Further, a driver circuit formed over a TFT array substrate may be formed using an N-type TFT and a P-type TFT, or one of an N-type TFT and a P-type TFT. Moreover, the crystallinity of a semiconductor film used for a TFT is not particularly limited, and either an amorphous semiconductor film or a crystalline semiconductor film may be used.

The light emitting element shown in this embodiment mode includes a layer containing bathophenanthroline. The layer containing bathophenanthroline has superior electron transporting properties, which results in reduction in driving voltage of the light emitting element.

In general, in order to increase the electron transporting properties of a light emitting element, the film thickness of the fifth layer 107 that includes an organic compound mixed with an alkali metal or an alkaline earth metal is required to be larger than that of the fourth layer 106. However, since the light emitting element of the invention uses bathophenanthroline that has superior electron transporting properties, the film thickness of the fifth layer 107 can be reduced.

A layer that includes an organic compound mixed with an alkali metal or an alkaline earth metal is formed by co-evaporation. According to the invention, however, a light emitting element can be manufactured without co-evaporation since a layer that has superior electron transporting properties is formed using bathophenanthroline. As a result, productivity can be increased.

If a layer is formed of an organic compound mixed with an alkali metal or an alkaline earth metal, the content of the alkali metal or the alkaline earth metal may significantly vary. This may cause variations in element resistance and variations in current-voltage characteristics of the element if the fifth layer 107 has a large film thickness. In the light emitting element of the invention, however, the film thickness of the fifth layer 107 is not necessarily increased. Therefore, a film with a nonuniform composition has a small influence on the element resistance. Further, if the fifth layer 107 is made of a compound of an alkali metal or the like, a film with a more uniform composition can be obtained, leading to increased yield.

When a light emitting element is manufactured without using metallic lithium or metallic cesium, which is expensive, a light emitting element with favorable properties can be obtained at a lower cost.

According to the invention, the fifth layer 107 can be formed without using an alkali metal as an evaporation source, and thus a light emitting element with low driving voltage can be manufactured. An alkali metal reacts actively, and an alkali metal in a thin film shape that is attached to a protection plate of an evaporation chamber or the like reacts with nitrogen to generate an unstable nitride when the alkali metal contacts with atmosphere during vent. Similarly, an alkali metal reacts with nitrogen to generate an unstable nitride when nitrogen is introduced during vent. For example, when metallic lithium is evaporated, lithium nitride is generated after vent. However, there is a fear that lithium nitride reacts with moisture and oxygen in atmosphere and ignites as a result. Therefore, it is danger to use an alkali metal such as lithium in mass production since accidents such as fire may occur. Accordingly, the use of a compound of an alkali metal or the like as an evaporation source allows the fifth layer 107 to be manufactured more safely.

When a light emitting element is manufactured without using metallic lithium or metallic cesium, which is expensive, a light emitting element with favorable properties can be obtained at a lower cost.

### [Embodiment Mode 2]

Described in this embodiment mode is a light emitting element having a structure different from that shown in Embodiment Mode 1. Note that in this specification, being composite means not only a simple mixture of two or more materials, but also a change into such a state that charges are transported between two materials through a mixture of the materials at a molecular level.

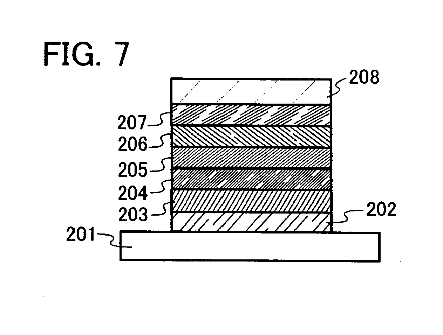

One mode of a light emitting element of the invention is described below with reference to FIG. 7A.

In this embodiment mode, a light emitting element has a structure in which a first electrode 202, a first layer 203, a second layer 204, a third layer 205, a fourth layer 206, a fifth layer 207, and a second electrode 208 are stacked in this order over a substrate 201. Note that the description of this embodiment mode is made assuming that the first electrode 202 functions as an anode while the second electrode 208 functions as a cathode.

The substrate 201 is used as a support of the light emitting element. The substrate 201 can be made of, for example, glass, plastic, or the like. Other materials may also be used as long as the substrate 201 can serve as a support in a manufacturing process of the light emitting element.

The first electrode 202 can be made of various metals, alloys, conductive compounds, or mixture metals of them. The first electrode 202 can be made of, for example, indium tin oxide (ITO), indium tin oxide containing silicon, or indium zinc oxide (IZO) in which 2 to 20 wt% of zinc oxide (ZnO) is added to indium oxide, as well as gold (Au), platinum (Pt), nickel (Ni), tungsten (W), chromium (Cr), molybdenum (Mo), iron (Fe), cobalt (Co), titanium (Ti), copper (Cu), palladium (Pd), aluminum (Al), aluminum-silicon (Al-Si), aluminum-titanium (Al-Ti), aluminum-silicon-copper (Al-Si-Cu), a metal nitride (TiN), or the like. Above all, if the first electrode 202 is used as an anode, it is preferably made of a material having a high work function (a work function of 4.0 eV or higher).

In the light emitting element of this embodiment mode, the first electrode 202 is not necessarily made of a material having a high work function, and may be made of a material having a low work function.

The first layer 203 is a layer containing a composite material of an organic compound and an inorganic compound. As the organic compound of the composite material, various compounds such as an aromatic amine compound, a carbazole derivative, aromatic hydrocarbon, and a high molecular compound (oligomer, dendrimer, polymer, or the like) can be used. The organic compound used for the composite material is preferably an organic compound having high hole transporting properties. Specifically, a substance having a hole mobility of 10⁻⁶ cm²/Vs or higher is preferably used. However, other substances than those may also be used as long as the hole transporting properties thereof are higher than the electron transporting properties thereof. The organic compound that can be used for the composite material is specifically shown below.

For example, the followings can be given as the aromatic amine compound: 4,4'-bis[*N*-(1-naphthyl)-*N*-phenylamino]biphenyl (abbreviation: NPB); *N*,*N*-diphenyl-*N*,*N*-bis(3-methylphenyl)-1,1-biphenyl-4,4-diamine (abbreviation: TPD); 4,4',4"-tris(*N*,*N*-diphenylamino)triphenylamine (abbreviation: TDATA); 4,4',4"-tris[*N*-(3-methylphenyl)-*N*-phenylamino]triphenylamine (abbreviation: MTDATA); and the like.

When the following organic compounds are used, a composite material that does not have a peak of an absorption spectrum in a wavelength region of 450 to 800 nm can be obtained.

As aromatic amine contained in a composite material that does not have a peak of an absorption spectrum in a wavelength region of 450 to 800 nm, the followings can be given: *N*,*N*'-di(*p*-tolyl)-*N*,*N*'-diphenyl-*p*-phenylenediamine (abbreviation: DTDPPA); 4,4'-bis[*N*-(4-diphenylaminophenyl)-*N*-phenylamino]biphenyl (abbreviation: DPAB); 4,4'-bis(*N*-{4-[*N*-(3-methylphenyl)-*N*-phenylamino]phenyl}-*N*-phenylamino)biphenyl (abbreviation: DNTPD); 1,3,5-tris[*N*-(4-diphenylaminophenyl)-*N*-phenylamino]benzene (abbreviation: DPA3B); and the like.

As the carbazole derivative that can be used for the composite material, the followings can be given specifically: 3-[*N*-(9-phenylcarbazole-3-yl)-*N*-phenylamino]-9-phenylcarbazole (abbreviation: PCzPCA1); 3,6-bis[*N*-(9-phenylcarbazole-3-yl)-*N*-phenylamino]-9-phenylcarbazole (abbreviation: PCzPCA2); 3-[*N*-(1-naphtyl)-*N*-(9-phenylcarbazole-3-yl)amino]-9-phenylcarbazole (abbreviation: PCzPCN1); and the like.

Moreover, 4,4'-di(N-carbazolyl)biphenyl (abbreviation: CBP); 1,3,5-tris[4-(*N*-carbazolyl)phenyl]benzene (abbreviation: TCPB); 9-[4-(*N*-carbazolyl)]phenyl-10-phenylanthracene (abbreviation: CzPA); 2,3,5,6-triphenyl-1,4-bis[4-(*N*-carbazolyl)phenyl]benzene; or the like can also be used.

As aromatic hydrocarbon that can be used for the composite material, the followings can be given for example: 9,10-di(naphthalene-2-yl)-2-*tert*-butylanthracene (abbreviation: t-BuDNA); 9,10-di(naphthalene-1-yl)-2-*tert*-butylanthracene; 9,10-bis(3,5-diphenylphenyl)anthracene (abbreviation: DPPA); 9,10-di(4-phenylphenyl)-2-*tert*-butylanthracene (abbreviation: t-BuDBA); 9,10-di(naphthalene-2-yl)anthracene (abbreviation: DNA); 9,10-diphenylanthracene (abbreviation: DPAnth); 2-*tert*-butylanthracene (abbreviation: t-BuAnth); 9,10-di(4-methylnaphthalene-1-yl)anthracene (abbreviation: DMNA); 2-*tert*-butyl-9,10-bis[2-(naphthalene-1-yl)phenyl]anthracene; 9,10-bis[2-(naphthalene-1-yl)phenyl]anthracene; 2,3,6,7-tetramethyl-9,10-di(naphthalene-1-yl)anthracene; 2,3,6,7-tetramethyl-9,10-di(naphthalene-2-yl)anthracene; 9,9'-bianthryl; 10,10'-diphenyl-9,9'-bianthryl; 10,10'-di(2-phenylphenyl)-9,9'-bianthryl; 10,10'-bis[(2,3,4,5,6-pentaphenyl)phenyl]-9,9'-bianthryl; anthracene; tetracene; rubrene; perylene; 2,5,8,11-tetra(*tert*-butyl)perylene; and the like. Besides, pentacene, coronene, or the like can also be used. It is particularly preferable to use such aromatic hydrocarbon that has a hole mobility of 1 × 10⁻⁶ cm²/Vs or higher and that has 14 to 42 carbon atoms.

Aromatic hydrocarbon that can be used for the composite material may have a vinyl skeleton. As aromatic hydrocarbon having a vinyl group, the followings can be given for example: 4,4'-bis(2,2-diphenylvinyl)biphenyl (abbreviation: DPVBi); 9,10-bis[4-(2,2-diphenylvinyl)phenyl]anthracene (abbreviation: DPVPA); and the like.

Moreover, a high molecular compound such as poly(*N*-vinylcarbazole) (abbreviation: PVK) and poly(4-vinyltriphenylamine) (abbreviation: PVTPA) can also be used.

As the inorganic compound used for the composite material, an oxide of a transition metal is preferably used. Moreover, an oxide of a metal belonging to any of groups 4 to 8 of the periodic table is preferably used. Specifically, it is preferable to use vanadium oxide, niobium oxide, tantalum oxide, chromium oxide, molybdenum oxide, tungsten oxide, manganese oxide, and rhenium oxide because of their high electron accepting properties. Above all, molybdenum oxide is particularly preferable since it is stable in the air, easily treated, and has low moisture absorption properties.

The composite material contained in the first layer 203 has superior hole injection properties and hole transporting properties, so that holes can be efficiently transported to the light emitting layer.

When the first layer 203 is made of the composite material of an organic compound and an inorganic compound, the first layer 203 can have an ohmic contact with the first electrode 202. Therefore, a material for the first electrode can be selected without considering the work function.

By selecting the kind of the organic compound contained in the composite material, a composite material that does not have a peak of an absorption spectrum in a wavelength region of 450 to 800 nm can be obtained. Therefore, light emitted from a light emitting region is not absorbed and transmits effectively, leading to improvement in light extraction efficiency.

Since the layer containing the composite material of an organic compound and an inorganic compound has high conductivity, an increase in driving voltage can be suppressed even if the layer containing the composite material has a large film thickness. Therefore, it becomes possible to optimize the film thickness of the layer containing the composite material so that light extraction efficiency increases while suppressing the increase in driving voltage. In addition, improvement in color purity by optical design can be achieved without increasing the driving voltage.

Since a short circuit due to depression and projection on the electrodes, shock, and the like can be prevented by increasing the film thickness of the layer containing the composite material, a light emitting element with high reliability can be obtained. For example, in contrast with the total film thickness of layers between the electrodes of a light emitting element, which generally ranges from 100 to 150 nm, the total film thickness of layers between the electrodes of the light emitting element using the layer containing the composite material can be made 100 to 500 nm, and preferably 200 to 500 nm.

A method for manufacturing the layer containing the composite material may be either a wet method or a dry method, and any method may be used. For example, the layer containing the composite material can be manufactured by co-evaporation of the aforementioned organic compound and inorganic compound. Further, the layer containing the composite material can also be obtained in such a way that a solution containing the aforementioned organic compound and metal alkoxide is applied and baked. Since molybdenum oxide is easily evaporated in vacuum, it is also preferably used from the aspect of a manufacturing process.

The second layer 204 is a layer containing a substance with high hole transporting properties. As the substance with high hole transporting properties, the substances with high hole transporting properties that are shown in Embodiment Mode 1 can be employed.

As the organic compound contained in the second layer 204, a carbazole derivative, aromatic hydrocarbon, or the like may be used instead of the aromatic amine compound. For example, aromatic hydrocarbon may be used as the organic compound contained in the first layer 203 and aromatic hydrocarbon may be used as the organic compound contained in the second layer 204. In this manner, a light emitting element that does not contain the amine compound can also be manufactured.

It is preferable that the organic compounds contained in the first layer 203 and the second layer 204 be formed of the same substance, because a carrier injection barrier between the first layer 203 and the second layer 204 becomes low. If the first layer 203 and the second layer 204 are formed by evaporation, they can be continuously formed; therefore, manufacturing steps can be simplified and the productivity can be further improved.

It is preferable that the organic compound contained in the second layer have the same or lower ionization potential than the organic compound contained in the first layer.

The third layer 205 is a layer containing a substance with high light emitting properties. The third layer 205 can adopt the structure shown in Embodiment Mode 1.

The fourth layer 206 is a layer containing bathophenanthroline (abbreviation: BPhen). Bathophenanthroline has superior electron transporting properties, and the fourth layer 206 made of bathophenanthroline allows the driving voltage of the light emitting element to be reduced.

The film thickness of the fourth layer 206 is preferably 10 to 100 nm, and more preferably 30 to 60 nm.

A layer containing a substance with high electron transporting properties may be provided between the third layer 205 and the fourth layer 206. As the substance with high electron transporting properties, the structure shown in Embodiment Mode 1 can be employed.

The fifth layer 207 is a layer having a function of promoting electron injection, and can adopt the structure shown in Embodiment Mode 1.

The second electrode 208 can also adopt the structure shown in Embodiment Mode 1.

The light emitting element shown in this embodiment mode includes a layer containing bathophenanthroline. The layer containing bathophenanthroline, which has superior electron transporting properties, allows the driving voltage of the light emitting element to be reduced.

The light emitting element shown in this embodiment mode includes a layer containing a composite material. The layer containing a composite material has superior hole injection properties and hole transporting properties, and the driving voltage of the light emitting element can be further reduced.

Since the light emitting element can be driven at a low voltage, heat generation of the light emitting element can be suppressed.

The light emitting element shown in this embodiment mode includes a layer containing a composite material of an organic compound and an inorganic compound, and a layer containing bathophenanthroline. The layer containing a composite material has superior hole injection properties and hole transporting properties, so that holes can be efficiently transported to the light emitting layer. On the other hand, bathophenanthroline has superior electron transporting properties, so that electrons can be efficiently transported to the light emitting layer. As a result, the invention can achieve the light emitting element with well-balanced holes and electrons injected to the light emitting layer, and with high light emitting efficiency.

In general, in order to increase the electron transporting properties of a light emitting element, the film thickness of the fifth layer 207 that includes an organic compound mixed with an alkali metal or an alkaline earth metal is required to be larger than that of the fourth layer 206. However, since the light emitting element of the invention uses bathophenanthroline that has superior electron transporting properties, the film thickness of the fifth layer 207 can be reduced.

A layer that includes an organic compound mixed with an alkali metal or an alkaline earth metal is formed by co-evaporation. According to the invention, however, a light emitting element can be manufactured without co-evaporation since a layer that has superior electron transporting properties is formed using bathophenanthroline. As a result, productivity can be increased.

If a layer is formed of an organic compound mixed with an alkali metal or an alkaline earth metal, the content of the alkali metal or the alkaline earth metal may significantly vary. This may cause variations in element resistance and variations in current-voltage characteristics of the element if the fifth layer 207 has a large film thickness. In the light emitting element of the invention, however, the film thickness of the fifth layer 207 is not necessarily increased. Therefore, a film with a nonuniform composition has a small influence on the element resistance. Further, if the fifth layer 207 is made of a compound of an alkali metal or the like, a film with a more uniform composition can be obtained, leading to increased yield.

When a light emitting element is manufactured without using metallic lithium or metallic cesium, which is expensive, a light emitting element with favorable properties can be obtained at a lower cost.

According to the invention, the fifth layer 207 can be formed without using an alkali metal as an evaporation source, and thus a light emitting element with low driving voltage can be manufactured. An alkali metal reacts actively, and an alkali metal in a thin film shape that is attached to a protection plate of an evaporation chamber or the like reacts with nitrogen to generate an unstable nitride or when the alkali metal contacts with atmosphere during vent. Similarly, an alkali metal reacts with nitrogen to generate an unstable nitride when nitrogen is introduced during vent. For example, when metallic lithium is evaporated, lithium nitride is generated after vent. However, there is a fear that lithium nitride reacts with moisture and oxygen in atmosphere and ignites as a result. Therefore, it is danger to use an alkali metal such as lithium in mass production since accidents such as fire may occur. Accordingly, the use of a compound of an alkali metal or the like as an evaporation source allows the fifth layer 207 to be manufactured more safely.

When a light emitting element is manufactured by using a compound of metallic lithium or metallic cesium, without using metallic lithium or metallic cesium, since it is expensive, a light emitting element with favorable properties can be obtained at a lower cost.

This embodiment mode can be appropriately combined with other embodiment modes.

### [Embodiment Mode 3]

In this embodiment mode, a light emitting device including a light emitting element of the invention is described.

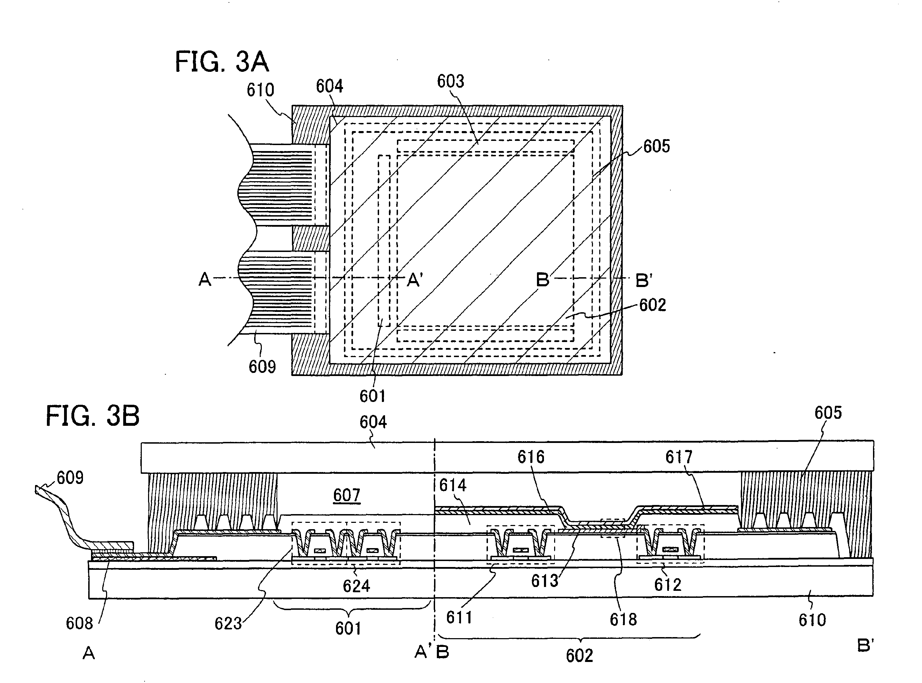

In this embodiment mode, a light emitting device including a light emitting element of the invention in a pixel portion is described with reference to FIGS. 3A and 3B. FIG 3A is a top view showing a light emitting device, and FIG 3B is a cross sectional view along a line A-A' and a line B-B' of FIG. 3A. Reference numeral 601 denotes a driver circuit portion (source driver circuit), 602 denotes a pixel portion, and 603 denotes a driver circuit portion (gate driver circuit), which are shown by a dotted line. Reference numeral 604 denotes a sealing substrate, 605 denotes a sealing member, and 607 denotes a space surrounded by the sealing member 605.

A lead wire 608 is a wire for transmitting signals to be inputted to the source driver circuit 601 and the gate driver circuit 603, and receives a video signal, a clock signal, a start signal, a reset signal, and the like from an FPC (Flexible Printed Circuit) 609 that is an external input terminal. Although only the FPC is shown here, a printed wiring board (PWB) may be attached to the FPC. The light emitting device in this specification includes not only the light emitting device itself, but also the FPC or the PWB attached to the light emitting device.

Next, a cross sectional structure is described with reference to FIG 3B. The driver circuit portions and the pixel portion are formed over an element substrate 610, though FIG. 3B shows the source driver circuit 601 that is the driver circuit portion and one pixel in the pixel portion 602.

The source driver circuit 601 includes a CMOS circuit formed by combining an N-channel TFT 623 and a P-channel TFT 624. Alternatively, the driver circuit may be formed using a PMOS circuit or an NMOS circuit. In this embodiment mode, the integrated driver circuit that is formed over the substrate is shown; however, the driver circuit is not necessarily formed over the substrate and may be formed outside the substrate.

The pixel portion 602 includes a plurality of pixels each having a switching TFT 611, a current controlling TFT 612, and a first electrode 613 that is electrically connected to a drain of the current controlling TFT 612. An insulator 614 is formed to cover an end portion of the first electrode 613. In this embodiment mode, the insulator 614 is formed of a positive photosensitive acrylic resin film.

In order to improve coverage, an upper end portion or a lower end portion of the insulator 614 is formed so as to have a curved surface with curvature. For example, if positive photosensitive acrylic is used for the insulator 614, it is preferable that only the upper end portion of the insulator 614 have a curved surface with a radius of curvature of 0.2 to 3 µm. The insulator 614 may be formed of either a negative photosensitive acrylic which becomes insoluble in etchant by irradiation with light or a positive photosensitive acrylic which becomes soluble in etchant by irradiation with light.

A layer 616 containing a light emitting substance and a second electrode 617 are formed over the first electrode 613. The first electrode 613 functioning as an anode can be made of various metals, alloys, conductive compounds, or mixture metals of them. If the first electrode is used as an anode, it is preferable to use, among those materials, a material having a high work function (work function of 4.0 eV or higher), or the like. For example, it is possible to use a single layer film of indium tin oxide containing silicon, indium zinc oxide (IZO) in which 2 to 20 wt% of zinc oxide (ZnO) is added to indium oxide, a titanium nitride film, a chromium film, a tungsten film, a Zn film, a Pt film, or the like. It is also possible to use a stacked layer structure of a film containing titanium nitride and a film mainly containing aluminum; a three-layer structure of a titanium nitride film, a film mainly containing aluminum, and a titanium nitride film; or the like. The stacked layer structure achieves to have a low wiring resistance, favorable ohmic contact, and a function as an anode.

The layer 616 containing a light emitting substance is formed by various methods such as evaporation using an evaporation mask, ink-jet printing, and spin coating. The layer 616 containing a light emitting substance has the layer containing the composite material shown in Embodiment Mode 1 and the layer containing the second organic compound shown in Embodiment Mode 2. As another material that constitutes the layer 616 containing a light emitting substance, a low molecular material, or a high molecular material (including oligomer and dendrimer) may be used. As the material for the layer containing a light emitting substance, an organic compound is often used as a single layer or a multilayer in general. However, the invention includes a structure in which an inorganic compound is used as a part of a film containing an organic compound.

The second electrode 617 that is formed over the layer 616 containing a light emitting substance and functions as a cathode can be made of a metal, an alloy, a conductive compound, a mixture of these, or the like, each having a low work function (a work function of 3.8 eV or lower). Specifically, an element belonging to group 1 or 2 of the periodic table, that is, an alkali metal such as lithium (Li) and cesium (Cs), an alkaline earth metal such as magnesium (Mg), calcium (Ca), and strontium (Sr), or an alloy containing these (Mg : Ag, Al : Li) can be used as a cathode material. If light generated in the layer 616 containing a light emitting substance is transmitted through the second electrode 617, the second electrode 617 can be formed using a stacked layer structure of a metal thin film and a transparent conductive film (ITO, indium oxide containing 2 to 20 wt% of zinc oxide, indium tin oxide containing silicon, zinc oxide (ZnO), or the like).

When the sealing substrate 604 and the element substrate 610 are attached to each other with the sealing member 605, the light emitting element 618 is provided in the space 607 surrounded by the element substrate 610, the sealing substrate 604, and the sealing member 605. The space 607 may be filled with filler, and may be filled with an inert gas (such as nitrogen and argon), the sealing member 605, or the like.

An epoxy-based resin is preferably used for the sealing member 605. The material preferably allows as little moisture and oxygen as possible to penetrate. As a material for the sealing substrate 604, a plastic substrate made of FRP (Fiberglass-Reinforced Plastics), PVF (polyvinyl fluoride), Mylar, polyester, acrylic, or the like can be used besides a glass substrate or a quartz substrate.

In this manner, the light emitting device including the light emitting element of the invention can be obtained.

The light emitting device of the invention includes the light emitting element shown in Embodiment Mode 1 or 2. The light emitting element of the invention can be driven at a low voltage, and the light emitting device including such a light emitting element has the advantage of low power consumption.

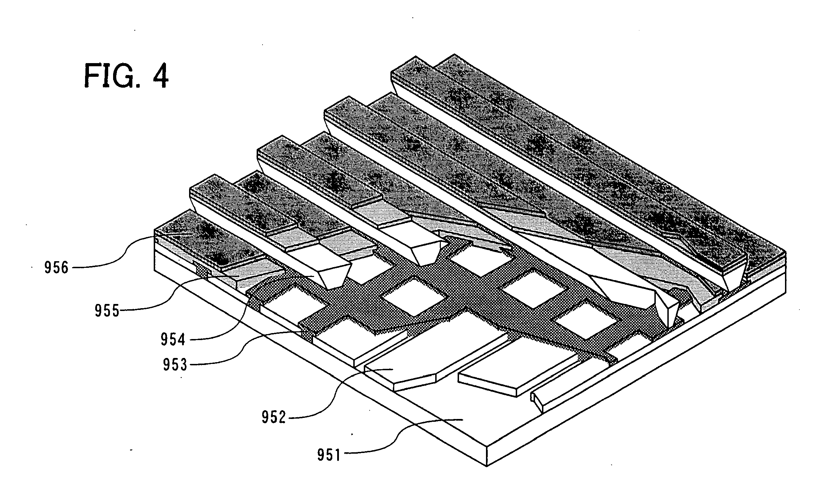

Although this embodiment mode has described the active light emitting device in which the driving of the light emitting element is controlled by the transistor, the invention may be applied to a passive light emitting device in which a light emitting element is driven without particularly providing a driving element such as a transistor. FIG 4 is a perspective view of a passive light emitting device manufactured by applying the invention. In FIG. 4, a layer 955 containing a light emitting substance is provided between an electrode 952 and an electrode 956 over a substrate 951. An end portion of the electrode 952 is covered with an insulating layer 953. Then, a partition wall layer 954 is provided over the insulating layer 953. A side wall of the partition wall layer 954 has such a gradient that the distance between one side wall and the other side wall becomes shorter as approaching the substrate surface. That is to say, a cross section of the partition wall layer 954 in a short side direction has a trapezoidal shape, in which a bottom side (a side in a similar direction to a surface direction of the insulating layer 953, which has contact with the insulating layer 953) is shorter than an upper side (a side in a similar direction to the surface direction of the insulating layer 953, which does not have contact with the insulating layer 953). By thus providing the partition wall layer 954, defects of a light emitting element due to static electricity and the like can be prevented. In addition, the passive light emitting device can also be driven with low power consumption by being provided with a light emitting element of the invention that has high light emitting efficiency and is driven at a low voltage.

### [Embodiment Mode 4]

Described in this embodiment mode is an electronic apparatus including the light emitting device shown in Embodiment Mode 3. The electronic apparatus of the invention includes the light emitting element shown in Embodiment Mode 1 or 2, and has a display portion with low power consumption. In addition, if the thickness of the layer containing a composite material shown in Embodiment Mode 2 increases, it is possible to suppress a short circuit due to minute foreign matter, external shock, or the like and provide an electronic apparatus including a display portion with high reliability.

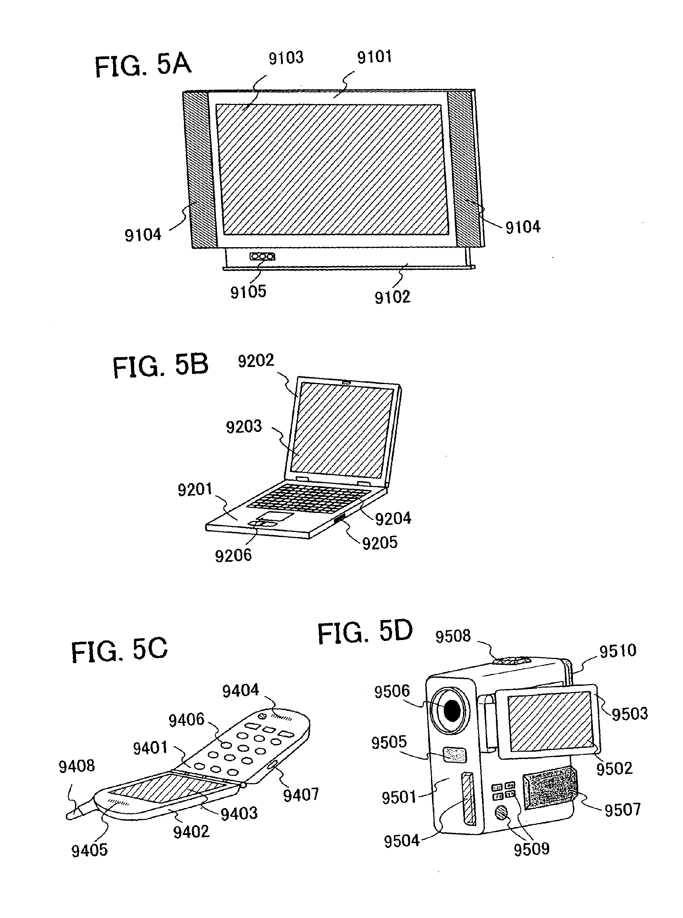

As the electronic apparatus manufactured using the light emitting device of the invention, the followings can be given: a camera such as a video camera and a digital camera, a goggle type display, a navigation system, an audio reproducing device (car audio system, audio component set, or the like), a computer, a game machine, a portable information terminal (mobile computer, cellular phone, portable game machine, electronic book, or the like), an image reproducing device provided with a recording medium (specifically, a device that reproduces a recording medium such as a DVD (Digital Versatile Disc) and has a display capable of displaying the reproduced image), and the like. Specific examples of these electronic apparatuses are shown in FIGS. 5A to 5D.

FIG. 5A shows a television set according to the invention, which includes a housing 9101, a supporting base 9102, a display portion 9103, speaker portions 9104, a video input terminal 9105, and the like. In the display portion 9103 of this television set, light emitting elements similar to those described in Embodiment Modes 1 and 2 are arranged in matrix. The light emitting elements have the advantages of high light emitting efficiency and low driving voltage. In addition, it is possible to prevent a short circuit due to minute foreign matter, external shock, or the like. Since the display portion 9103 including such light emitting elements has similar advantages, the television set can provide high image quality and achieve low power consumption. Such advantages allow degradation compensation functions and power supply circuits of the television set to be considerably reduced or downsized. Accordingly, reduction in size and weight of the housing 9101 and the supporting base 9102 can be achieved. With low power consumption, high image quality, and reduced size and weight, the television set of the invention can be manufactured so as to be suitable for living conditions.

FIG 5B shows a computer according to the invention, which includes a main body 9201, a housing 9202, a display portion 9203, a keyboard 9204, an external connecting port 9205, a pointing mouse 9206, and the like. In the display portion 9203 of this computer, light emitting elements similar to those described in Embodiment Modes 1 and 2 are arranged in matrix. The light emitting elements have the advantages of high light emitting efficiency and low driving voltage. In addition, it is possible to prevent a short circuit due to minute foreign matter, external shock, or the like. Since the display portion 9203 including such light emitting elements has similar advantages, the computer can provide high image quality and achieve low power consumption. Such advantages allow degradation compensation functions and power supply circuits of the computer to be considerably reduced or downsized. Accordingly, reduction in size and weight of the main body 9201 and the housing 9202 can be achieved. With low power consumption, high image quality, and reduced size and weight, the computer of the invention can be manufactured so as to be suitable for conditions. Further, the computer can be carried around, and it is possible to provide a computer including a display portion that is highly resistant to shock even when dropped.

FIG 5C shows a cellular phone according to the invention, which includes a main body 9401, a housing 9402, a display portion 9403, an audio input portion 9404, an audio output portion 9405, an operating key 9406, an external connecting port 9407, an antenna 9408, and the like. In the display portion 9403 of this cellular phone, light emitting elements similar to those described in Embodiment Modes 1 and 2 are arranged in matrix. The light emitting elements have the advantages of high light emitting efficiency and low driving voltage. In addition, it is possible to prevent a short circuit due to minute foreign matter, external shock, or the like. Since the display portion 9403 including such light emitting elements has similar advantages, the cellular phone can provide high image quality and achieve low power consumption. Such advantages allow degradation compensation functions and power supply circuits of the cellular phone to be considerably reduced or downsized. Accordingly, reduction in size and weight of the main body 9401 and the housing 9402 can be achieved. With low power consumption, high image quality, and reduced size and weight, the cellular phone of the invention can be manufactured so as to be suitable for carrying around. Further, it is possible to provide a cellular phone including a display portion that is highly resistant to shock even when dropped.

FIG 5D shows a camera according to the invention, which includes a main body 9501, a display portion 9502, a housing 9503, an external connecting port 9504, a remote control receiving portion 9505, an image receiving portion 9506, a battery 9507, an audio input portion 9508, operating keys 9509, an eyepiece portion 9510, and the like. In the display portion 9502 of this camera, light emitting elements similar to those described in Embodiment Modes 1 and 2 are arranged in matrix. The light emitting elements have the advantages of high light emitting efficiency and low driving voltage. In addition, it is possible to prevent a short circuit due to minute foreign matter, external shock, or the like. Since the display portion 9502 including such light emitting elements has similar advantages, the camera can provide high image quality and achieve low power consumption. Such advantages allow degradation compensation functions and power supply circuits of the camera to be considerably reduced or downsized. Accordingly, reduction in size and weight of the main body 9501 can be achieved. With low power consumption, high image quality, and reduced size and weight, the camera of the invention can be manufactured so as to be suitable for carrying around. Further, it is possible to provide a camera including a display portion that is highly resistant to shock even when dropped.

As set forth above, the application range of the light emitting device of the invention is so wide that the light emitting device can be applied to electronic apparatuses of all fields. The use of the light emitting device of the invention allows an electronic apparatus including a display portion with low power consumption and high reliability to be provided.

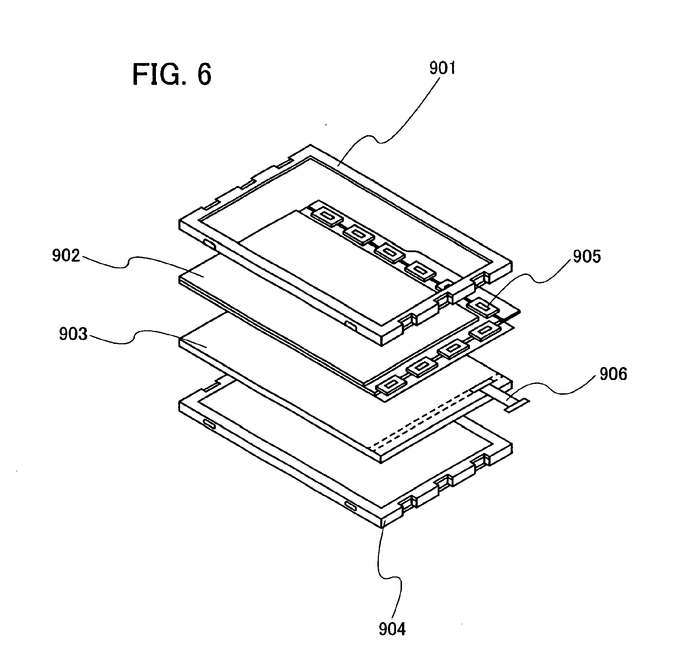

Moreover, the light emitting device of the invention, which includes a light emitting element with high light emitting efficiency, can also be used as a lighting device. One mode of the light emitting element of the invention used as a lighting device is described with reference to FIG 6.

FIG 6 shows an example of a liquid crystal display device using the light emitting device of the invention as a backlight. The liquid crystal display device shown in FIG 6 includes a housing 901, a liquid crystal layer 902, a backlight 903, and a housing 904. The liquid crystal layer 902 is connected to a driver IC 905. The light emitting device of the invention is used for the backlight 903, and current is supplied to the backlight 903 through a terminal 906.

When the light emitting device of the invention is used as the backlight of the liquid crystal display device, power consumption of the backlight can be reduced. In addition, the light emitting device of the invention is a surface emitting lighting device and can be increased in area; therefore, the area of the backlight as well as the area of the liquid crystal display device can be increased. Further, the light emitting device with a thin thickness and low power consumption allows the display device to be reduced in thickness and power consumption.

### [Embodiment 1]

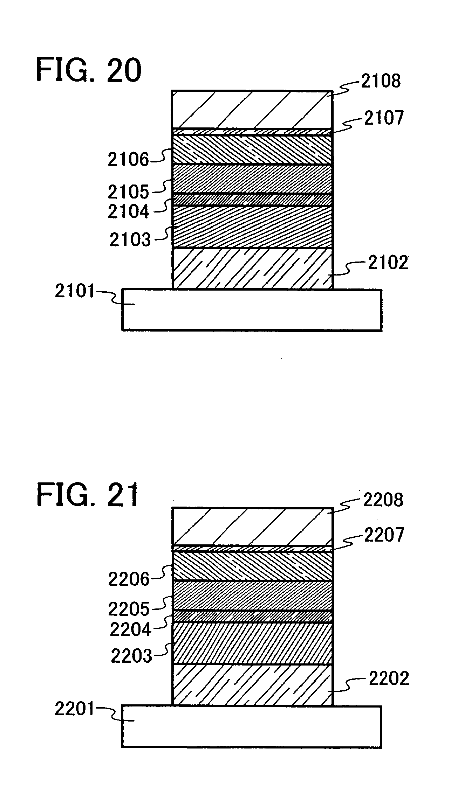

In this embodiment, a light emitting element of the invention is described with reference to FIG 20.

First, indium tin oxide containing silicon oxide is deposited over a glass substrate 2101 by sputtering, thereby forming a first electrode 2102. The first electrode 2102 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and DNTPD is deposited over the first electrode 2102 by evaporation using resistance heating so as to have a thickness of 50 nm, thereby forming a hole injection layer 2103.

Then, NPB is deposited over the hole injection layer 2103 by evaporation using resistance heating so as to have a thickness of 10 nm, thereby forming a hole transporting layer 2104.

Further, a light emitting layer 2105 with a thickness of 30 nm is formed over the hole transporting layer 2104 by co-evaporating 9-[4-(*N*-carbazolyl)]phenyl-10-phenylanthracene (abbreviation: CzPA) represented by the structural formula (2) and 9-(4-{*N*-[4-(9-carbazolyl)phenyl]-*N*-phenylamino}phenyl)-10-phenylanthracene (abbreviation: YGAPA) represented by the structural formula (3). Here, the weight ratio between CzPA and YGAPA is adjusted so as to be 1 : 0.04 (= CzPA : YGAPA). A co-evaporation method is an evaporation method by which evaporation is carried out from a plurality of evaporation sources at the same time within one process chamber.

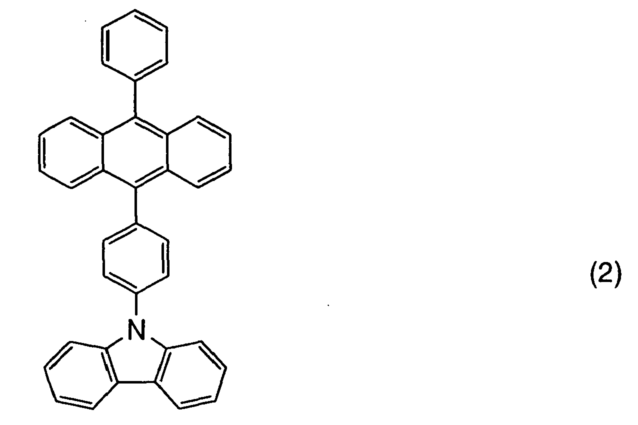

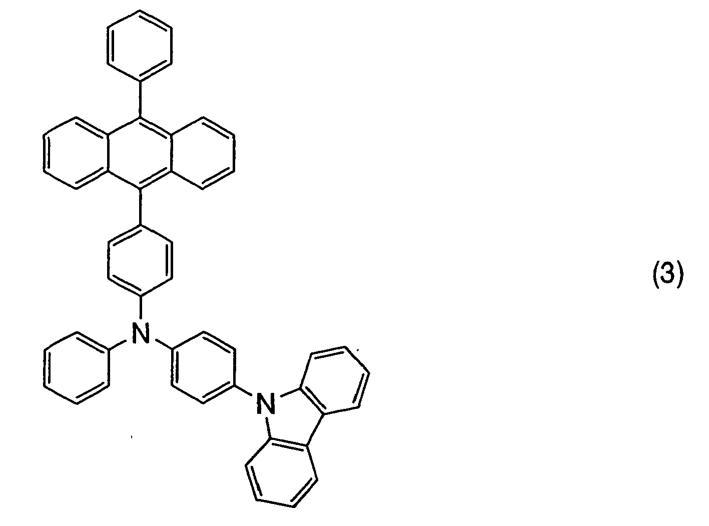

Then, bathophenanthroline (product of Tokyo Kasei Kogyo Co., Ltd.) is deposited over the light emitting layer 2105 by evaporation using resistance heating so as to have a thickness of 30 nm, thereby forming an electron transporting layer 2106.

Further, lithium fluoride is deposited over the electron transporting layer 2106 so as to have a thickness of 1 nm, thereby forming an electron injection layer 2107.

Lastly, aluminum is deposited over the electron injection layer 2107 by evaporation using resistance heating so as to have a thickness of 200 nm, thereby forming a second electrode 2108. Thus, the light emitting element of Embodiment 1 is completed. After that, the light emitting element is sealed and baked in a constant temperature bath at 85°C, then crystallization of the light emitting element is not observed. This baked light emitting element is used for measurement.

### (Comparative Example 1)

A light emitting element of the comparative example 1 is manufactured so as to have a similar structure to that of Embodiment 1 except that the electron transporting layer 2106 is formed to have a thickness of 30 nm using Alq. The light emitting element of the comparative example 1 is also sealed and baked in a constant temperature bath at 85°C, and then used for measurement.

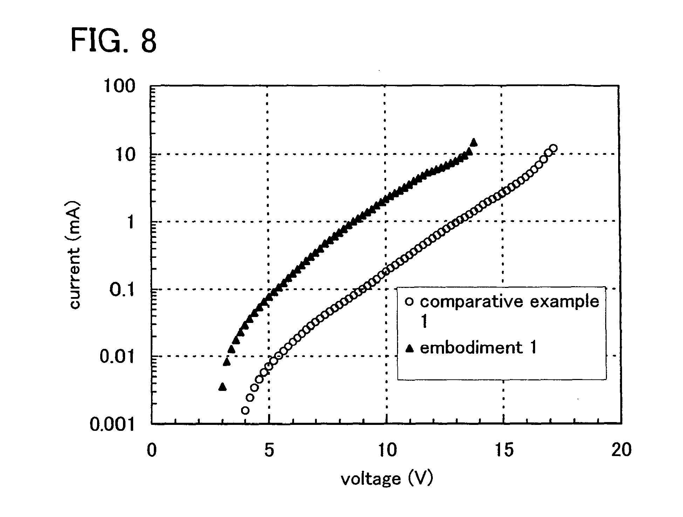

FIG. 8 shows the current-voltage characteristics of the light emitting element of Embodiment 1 and the light emitting element of the comparative example 1. FIG 8 shows that the current-voltage characteristics of the light emitting element of Embodiment 1 are improved as compared with the light emitting element of the comparative example 1. That is, it is understood that a larger current flows to the light emitting element when a constant voltage is applied. Accordingly, it is found that the light emitting element of the invention can be driven at a low voltage. [Embodiment 2]

In this embodiment, a light emitting element of the invention is described with reference to FIG 20.

First, indium tin oxide containing silicon oxide is deposited over the glass substrate 2101 by sputtering, thereby forming the first electrode 2102. The first electrode 2102 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and DNTPD is deposited over the first electrode 2102 by evaporation using resistance heating so as to have a thickness of 50 nm, thereby forming the hole injection layer 2103.

Then, NPB is deposited over the hole injection layer 2103 by evaporation using resistance heating so as to have a thickness of 10 nm, thereby forming the hole transporting layer 2104.

Further, the light emitting layer 2105 with a thickness of 40 nm is formed over the hole transporting layer 2104 by co-evaporating Alq and coumarin 6. Here, the weight ratio between Alq and coumarin 6 is adjusted so as to be 1 : 0.01 (= AIq : coumarin 6).

Then, bathophenanthroline (product of Tokyo Kasei Kogyo Co., Ltd.) is deposited over the light emitting layer 2105 by evaporation using resistance heating so as to have a thickness of 30 nm, thereby forming the electron transporting layer 2106.

Further, lithium fluoride is deposited over the electron transporting layer 2106 so as to have a thickness of 1 nm, thereby forming the electron injection layer 2107.

Lastly, aluminum is deposited over the electron injection layer 2107 by evaporation using resistance heating so as to have a thickness of 200 nm, thereby forming the second electrode 2108. Thus, the light emitting element of Embodiment 2 is completed. After that, the light emitting element is sealed and baked in a constant temperature bath at 85°C, then crystallization of the light emitting element is not observed. This baked light emitting element is used for measurement. [Embodiment 3]

In this embodiment, a specific example of a light emitting element of the invention is described with reference to FIG. 21.

First, indium tin oxide containing silicon oxide is deposited over a glass substrate 2201 by sputtering, thereby forming a first electrode 2202. The first electrode 2202 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and a layer containing a composite material 2203 is formed over the first electrode 2202 by co-evaporating DNTPD and molybdenum oxide (VI). The layer containing a composite material 2203 has a thickness of 50 nm, and the volume ratio between DNTPD and molybdenum oxide (VI) is adjusted so that molybdenum oxide is contained by 13 vol%.

Then, NPB is deposited over the layer containing a composite material 2203 by evaporation using resistance heating so as to have a thickness of 10 nm, thereby forming a hole transporting layer 2204.

Further, a light emitting layer 2205 with a thickness of 40 nm is formed over the hole transporting layer 2204 by co-evaporating Alq and coumarin 6. Here, the weight ratio between Alq and coumarin 6 is adjusted so as to be 1 : 0.01 (= Alq : coumarin 6).

Then, bathophenanthroline (product of Tokyo Kasei Kogyo Co., Ltd.) is deposited over the light emitting layer 2205 by evaporation using resistance heating so as to have a thickness of 30 nm, thereby forming an electron transporting layer 2206.

Further, lithium fluoride is deposited over the electron transporting layer 2206 so as to have a thickness of 1 nm, thereby forming an electron injection layer 2207.

Lastly, aluminum is deposited over the electron injection layer 2207 by evaporation using resistance heating so as to have a thickness of 200 nm, thereby forming a second electrode 2208. Thus, the light emitting element of Embodiment 3 is completed. After that, the light emitting element is sealed and baked in a constant temperature bath at 85°C, then crystallization of the light emitting element is not observed. This baked light emitting element is used for measurement.

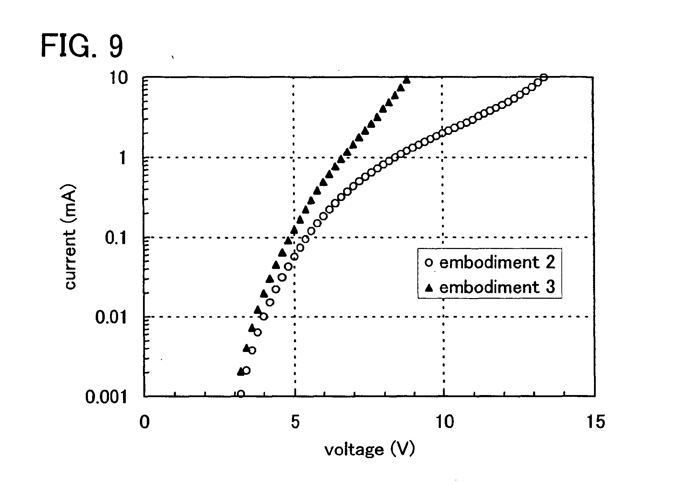

FIG 9 shows the current-voltage characteristics of the light emitting element of Embodiment 2 and the light emitting element of Embodiment 3. FIG 9 shows that both the light emitting element of Embodiment 2 and the light emitting element of Embodiment 3 exhibit excellent current-voltage characteristics. That is, it is understood that a larger current flows to the light emitting elements when a constant voltage is applied. Accordingly, it is found that the light emitting elements of the invention can be driven at a low voltage.

In addition, it is understood that a current flows more easily to the light emitting element of Embodiment 3, which includes the layer containing a composite material, than to the light emitting element of Embodiment 2, which does not include the layer containing a composite material. Accordingly, it is found that the light emitting element including the layer containing a composite material can be driven at a lower voltage.

### [Embodiment 4]

In this embodiment, a specific example of a light emitting element of the invention is described with reference to FIG. 21.

First, indium tin oxide containing silicon oxide is deposited over the glass substrate 2201 by sputtering, thereby forming the first electrode 2202. The first electrode 2202 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2203 is formed over the first electrode 2202 by co-evaporating t-BuDNA and molybdenum oxide (VI). The layer containing a composite material 2203 has a thickness of 50 nm, and the volume ratio between t-BuDNA and molybdenum oxide (VI) is adjusted so that molybdenum oxide is contained by 10 vol%.

Then, NPB is deposited over the layer containing a composite material 2203 by evaporation using resistance heating so as to have a thickness of 10 nm, thereby forming the hole transporting layer 2204.

Further, the light emitting layer 2205 with a thickness of 30 nm is formed over the hole transporting layer 2204 by co-evaporating NPB and (acetylacetonate)bis[2,3-bis(4-fluorophenyl)quinoxalinato]iridium(III) (abbreviation: Ir(Fdpq)₂(acac)) represented by the structural formula (4). Here, the weight ratio between NPB and Ir(Fdpq)₂(acac) is adjusted so as to be 1 : 0.08 (= NPB : Ir(Fdpq)₂(acac)).

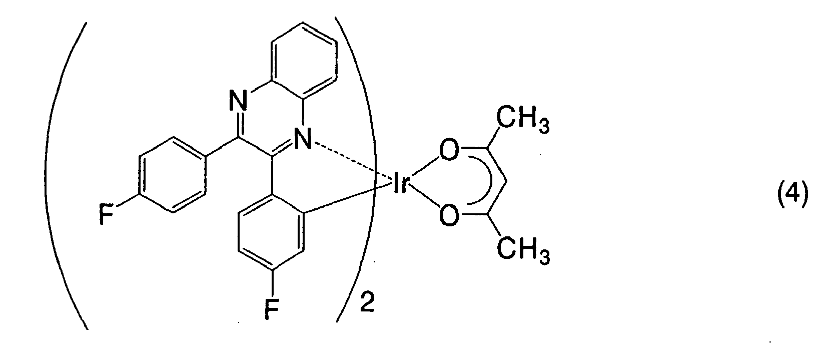

Then, bathophenanthroline (product of Tokyo Kasei Kogyo Co., Ltd.) is deposited over the light emitting layer 2205 by evaporation using resistance heating so as to have a thickness of 60 nm, thereby forming the electron transporting layer 2206.

Further, lithium fluoride is deposited over the electron transporting layer 2206 so as to have a thickness of 1 nm, thereby forming the electron injection layer 2207.

Lastly, aluminum is deposited over the electron injection layer 2207 by evaporation using resistance heating so as to have a thickness of 200 nm, thereby forming the second electrode 2208. Thus, the light emitting element of Embodiment 4 is completed. After that, the light emitting element is sealed and baked in a constant temperature bath at 85°C, then crystallization of the light emitting element is not observed. This baked light emitting element is used for measurement.

### (Comparative Example 2)

As a comparative light emitting element, a light emitting element having the following structure is manufactured.

First, indium tin oxide containing silicon oxide is deposited over the glass substrate 2201 by sputtering, thereby forming the first electrode 2202. The first electrode 2202 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2203 is formed over the first electrode 2202 by co-evaporating DNTPD and molybdenum oxide (VI). The layer containing a composite material 2203 has a thickness of 50 nm, and the volume ratio between DNTPD and molybdenum oxide (VI) is adjusted so that molybdenum oxide is contained by 13 vol%.

Then, NPB is deposited over the layer containing a composite material 2203 by evaporation using resistance heating so as to have a thickness of 10 nm, thereby forming the hole transporting layer 2204.

Further, the light emitting layer 2205 with a thickness of 30 nm is formed over the hole transporting layer 2204 by co-evaporating NPB and (acetylacetonate)bis[2,3-bis(4-fluorophenyl)quinoxalinato]iridium(III) (abbreviation: Ir(Fdpq)₂(acac)) represented by the structural formula (4). Here, the weight ratio between NPB and Ir(Fdpq)₂(acac) is adjusted so as to be 1 : 0.08 (= NPB : Ir(Fdpq)₂(acac)).

Then, Alq is deposited over the light emitting layer 2205 by evaporation using resistance heating so as to have a thickness of 60 nm, thereby forming the electron transporting layer 2206.

Further, lithium fluoride is deposited over the electron transporting layer 2206 so as to have a thickness of 1 nm, thereby forming the electron injection layer 2207.

Lastly, aluminum is deposited over the electron injection layer 2207 by evaporation using resistance heating so as to have a thickness of 200 nm, thereby forming the second electrode 2208. Thus, the light emitting element of the comparative example 2 is completed. The light emitting element of the comparative example 2 is also sealed and baked in a constant temperature bath at 85°C, and used for measurement.

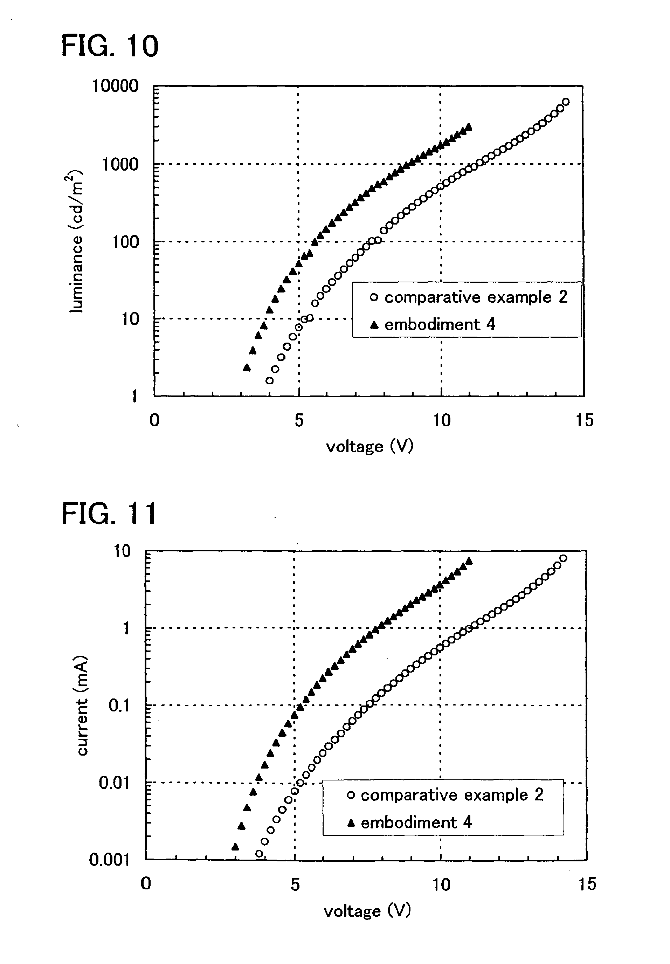

FIG 10 shows the luminance-voltage characteristics of the light emitting element of Embodiment 4 and the light emitting element of the comparative example 2, whereas FIG 11 shows the current-voltage characteristics of them. FIG. 10 and FIG. 11 show that both the luminance-voltage characteristics and the current-voltage characteristics of the light emitting element of Embodiment 4 are improved as compared with the light emitting element of the comparative example 2. That is, it is understood that a larger current flows to the light emitting element and higher luminance is obtained when a constant voltage is applied. Accordingly, it is found that the light emitting element of the invention can be driven at a low voltage. [Embodiment 5]

In this embodiment, a specific example of a light emitting element of the invention is described with reference to FIG. 21.

First, indium tin oxide containing silicon oxide is deposited over the glass substrate 2201 by sputtering, thereby forming the first electrode 2202. The first electrode 2202 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2203 is formed over the first electrode 2202 by co-evaporating t-BuDNA and molybdenum oxide (VI). The layer containing a composite material 2203 has a thickness of 50 nm, and the volume ratio between t-BuDNA and molybdenum oxide (VI) is adjusted so that molybdenum oxide is contained by 10 vol%.

Then, NPB is deposited over the layer containing a composite material 2203 by evaporation using resistance heating so as to have a thickness of 10 nm, thereby forming the hole transporting layer 2204.

Further, the light emitting layer 2205 with a thickness of 40 nm is formed over the hole transporting layer 2204 by co-evaporating Alq and DPQd. Here, the weight ratio between Alq and DPQd is adjusted so as to be 1 : 0.003 (= Alq : DPQd).

Then, bathophenanthroline (product of Tokyo Kasei Kogyo Co., Ltd.) is deposited over the light emitting layer 2205 by evaporation using resistance heating so as to have a thickness of 30 nm, thereby forming the electron transporting layer 2206.

Further, lithium fluoride is deposited over the electron transporting layer 2206 so as to have a thickness of 1 nm, thereby forming the electron injection layer 2207.

Lastly, aluminum is deposited over the electron injection layer 2207 by evaporation using resistance heating so as to have a thickness of 200 nm, thereby forming the second electrode 2208. Thus, the light emitting element of Embodiment 5 is completed. After that, the light emitting element is sealed and baked in a constant temperature bath at 85°C, then crystallization of the light emitting element is not observed. This baked light emitting element is used for measurement.

### (Comparative Example 3)

As a comparative light emitting element, a light emitting element having the following structure is manufactured.

First, indium tin oxide containing silicon oxide is deposited over the glass substrate 2201 by sputtering, thereby forming the first electrode 2202. The first electrode 2202 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2203 is formed over the first electrode 2202 by co-evaporating DNTPD and molybdenum oxide (VI). The layer containing a composite material 2203 has a thickness of 50 nm, and the volume ratio between DNTPD and molybdenum oxide (VI) is adjusted so that molybdenum oxide is contained by 13 vol%.

Then, NPB is deposited over the layer containing a composite material 2203 by evaporation using resistance heating so as to have a thickness of 10 nm, thereby forming the hole transporting layer 2204.

Further, the light emitting layer 2205 with a thickness of 40 nm is formed over the hole transporting layer 2204 by co-evaporating Alq and DPQd. Here, the weight ratio between Alq and DPQd is adjusted so as to be 1 : 0.003 (= Alq : DPQd).

Then, Alq is deposited over the light emitting layer 2205 by evaporation using resistance heating so as to have a thickness of 30 nm, thereby forming the electron transporting layer 2206.

Further, lithium fluoride is deposited over the electron transporting layer 2206 so as to have a thickness of 1 nm, thereby forming the electron injection layer 2207.

Lastly, aluminum is deposited over the electron injection layer 2207 by evaporation using resistance heating so as to have a thickness of 200 nm, thereby forming the second electrode 2208. Thus, the light emitting element of the comparative example 3 is completed. The light emitting element of the comparative example 3 is also sealed and baked in a constant temperature bath at 85°C, and used for measurement.

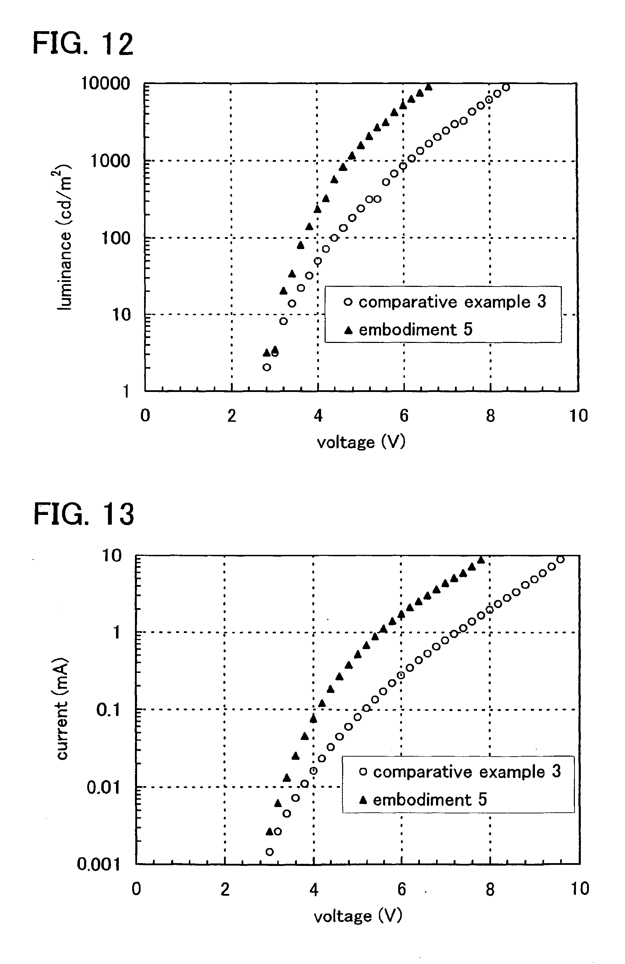

FIG 12 shows the luminance-voltage characteristics of the light emitting element of Embodiment 5 and the light emitting element of the comparative example 3, whereas FIG. 13 shows the current-voltage characteristics of them. FIG 12 and FIG 13 show that both the luminance-voltage characteristics and the current-voltage characteristics of the light emitting element of Embodiment 5 are improved as compared with the light emitting element of the comparative example 3. That is, it is understood that a larger current flows to the light emitting element and higher luminance is obtained when a constant voltage is applied. Accordingly, it is found that the light emitting element of the invention can be driven at a low voltage. [Embodiment 6]

In this embodiment, a specific example of a light emitting element of the invention is described with reference to FIG. 21.

First, indium tin oxide containing silicon oxide is deposited over the glass substrate 2201 by sputtering, thereby forming the first electrode 2202. The first electrode 2202 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2203 is formed over the first electrode 2202 by co-evaporating t-BuDNA and molybdenum oxide (VI). The layer containing a composite material 2203 has a thickness of 50 nm, and the volume ratio between t-BuDNA and molybdenum oxide (VI) is adjusted so that molybdenum oxide is contained by 10 vol%.

Then, NPB is deposited over the layer containing a composite material 2203 by evaporation using resistance heating so as to have a thickness of 10 nm, thereby forming the hole transporting layer 2204.

Further, the light emitting layer 2205 with a thickness of 30 nm is formed over the hole transporting layer 2204 by co-evaporating 9-[4-(*N*-carbazolyl)]phenyl-10-phenylanthracene (abbreviation: CzPA) represented by the structural formula (2) and 9-(4-{*N*-[4-(9-carbazolyl)phenyl]-*N*-phenylamino}phenyl)-10-phenylanthracene (abbreviation: YGAPA) represented by the structural formula (3). Here, the weight ratio between CzPA and YGAPA is adjusted so as to be 1 : 0.04 (= CzPA : YGAPA).

Then, bathophenanthroline (product of Tokyo Kasei Kogyo Co., Ltd.) is deposited over the light emitting layer 2205 by evaporation using resistance heating so as to have a thickness of 30 nm, thereby forming the electron transporting layer 2206.

Further, lithium fluoride is deposited over the electron transporting layer 2206 so as to have a thickness of 1 nm, thereby forming the electron injection layer 2207.

Lastly, aluminum is deposited over the electron injection layer 2207 by evaporation using resistance heating so as to have a thickness of 200 nm, thereby forming the second electrode 2208. Thus, the light emitting element of Embodiment 6 is completed. After that, the light emitting element is sealed and baked in a constant temperature bath at 85°C, then crystallization of the light emitting element is not observed. This baked light emitting element is used for measurement.

### (Comparative Example 4)

As a comparative light emitting element, a light emitting element having the following structure is manufactured.

First, indium tin oxide containing silicon oxide is deposited over the glass substrate 2201 by sputtering, thereby forming the first electrode 2202. The first electrode 2202 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2203 is formed over the first electrode 2202 by co-evaporating DNTPD and molybdenum oxide (VI). The layer containing a composite material 2203 has a thickness of 50 nm, and the volume ratio between DNTPD and molybdenum oxide (VI) is adjusted so that molybdenum oxide is contained by 13 vol%.

Then, NPB is deposited over the layer containing a composite material 2203 by evaporation using resistance heating so as to have a thickness of 10 nm, thereby forming the hole transporting layer 2204.

Further, the light emitting layer 2205 with a thickness of 30 nm is formed over the hole transporting layer 2204 by co-evaporating CzPA and YGAPA. Here, the weight ratio between CzPA and YGAPA is adjusted so as to be 1 : 0.04 (= CzPA : YGAPA).

Then, Alq is deposited over the light emitting layer 2205 by evaporation using resistance heating so as to have a thickness of 30 nm, thereby forming the electron transporting layer 2206.

Further, lithium fluoride is deposited over the electron transporting layer 2206 so as to have a thickness of 1 nm, thereby forming the electron injection layer 2207.

Lastly, aluminum is deposited over the electron injection layer 2207 by evaporation using resistance heating so as to have a thickness of 200 nm, thereby forming the second electrode 2208. Thus, the light emitting element of the comparative example 4 is completed. The light emitting element of the comparative example 4 is also sealed and baked in a constant temperature bath at 85°C, and used for measurement.

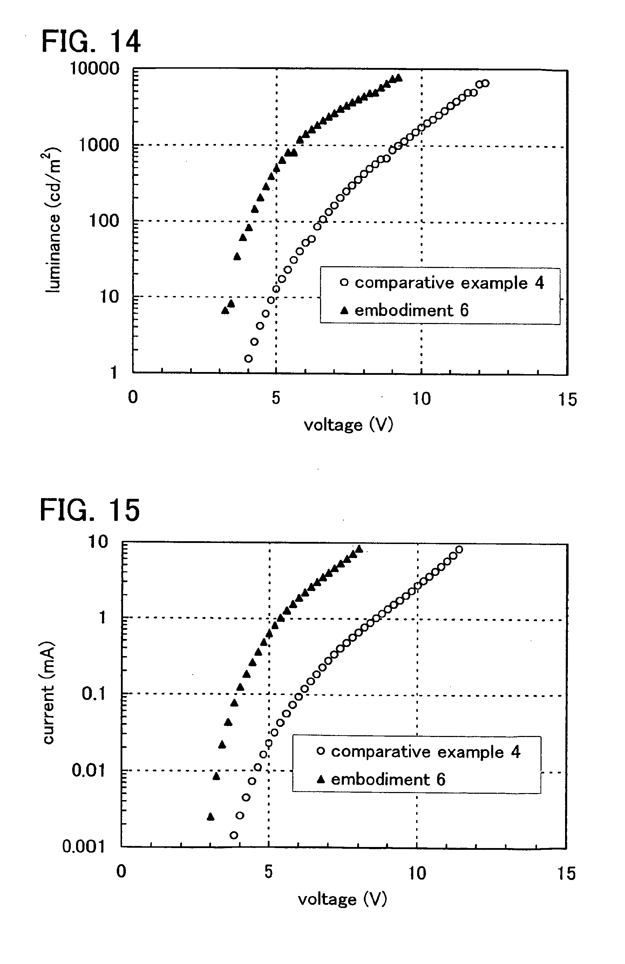

FIG 14 shows the luminance-voltage characteristics of the light emitting element of Embodiment 6 and the light emitting element of the comparative example 4, whereas FIG. 15 shows the current-voltage characteristics of them. FIG. 14 and FIG. 15 show that both the luminance-voltage characteristics and the current-voltage characteristics of the light emitting element of Embodiment 6 are improved as compared with the light emitting element of the comparative example 4. That is, it is understood that a larger current flows to the light emitting element and higher luminance is obtained when a constant voltage is applied. Accordingly, it is found that the light emitting element of the invention can be driven at a low voltage. [Embodiment 7]

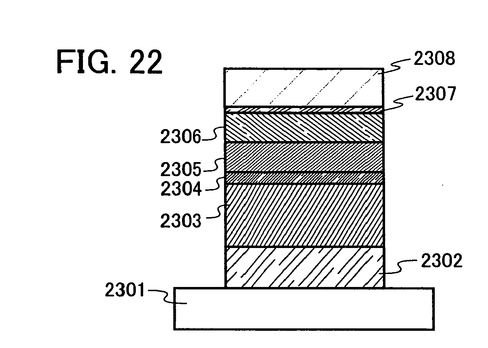

In this embodiment, a specific example of a light emitting element of the invention is described with reference to FIG. 22.

First, indium tin oxide containing silicon oxide is deposited over a glass substrate 2301 by sputtering, thereby forming a first electrode 2302. The first electrode 2302 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and a layer containing a composite material 2303 is formed over the first electrode 2302 by co-evaporating DNTPD and molybdenum oxide (VI). The layer containing a composite material 2303 has a thickness of 150 nm, and the volume ratio between DNTPD and molybdenum oxide (VI) is adjusted so that molybdenum oxide is contained by 13 vol%.

Then, NPB is deposited over the layer containing a composite material 2303 by evaporation using resistance heating so as to have a thickness of 10 nm, thereby forming a hole transporting layer 2304.

Further, a light emitting layer 2305 with a thickness of 40 nm is formed over the hole transporting layer 2304 by co-evaporating Alq and coumarin 6. Here, the weight ratio between Alq and coumarin 6 is adjusted so as to be 1 : 0.01 (= Alq : coumarin 6).

Then, bathophenanthroline (product of Tokyo Kasei Kogyo Co., Ltd.) is deposited over the light emitting layer 2305 by evaporation using resistance heating so as to have a thickness of 30 nm, thereby forming an electron transporting layer 2306.

Further, lithium fluoride is deposited over the electron transporting layer 2306 so as to have a thickness of 1 nm, thereby forming an electron injection layer 2307.

Lastly, aluminum is deposited over the electron injection layer 2307 by evaporation using resistance heating so as to have a thickness of 200 nm, thereby forming a second electrode 2308. Thus, the light emitting element of Embodiment 7 is completed. After that, the light emitting element is sealed and baked in a constant temperature bath at 85°C, then crystallization of the light emitting element is not observed. This baked light emitting element is used for measurement.

### (Comparative Example 5)

As a comparative light emitting element, a light emitting element having the following structure is manufactured.

First, indium tin oxide containing silicon oxide is deposited over the glass substrate 2301 by sputtering, thereby forming the first electrode 2302. The first electrode 2302 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2303 is formed over the first electrode 2302 by co-evaporating DNTPD and molybdenum oxide (VI). The layer containing a composite material 2303 has a thickness of 150 nm, and the volume ratio between DNTPD and molybdenum oxide (VI) is adjusted so that molybdenum oxide is contained by 13 vol%.

Then, NPB is deposited over the layer containing a composite material 2303 by evaporation using resistance heating so as to have a thickness of 10 nm, thereby forming the hole transporting layer 2304.

Further, the light emitting layer 2305 with a thickness of 40 nm is formed over the hole transporting layer 2304 by co-evaporating Alq and coumarin 6. Here, the weight ratio between Alq and coumarin 6 is adjusted so as to be 1 : 0.01 (= Alq : coumarin 6).

Then, Alq is deposited over the light emitting layer 2305 by evaporation using resistance heating so as to have a thickness of 30 nm, thereby forming the electron transporting layer 2306.

Further, lithium fluoride is deposited over the electron transporting layer 2306 so as to have a thickness of 1 nm, thereby forming the electron injection layer 2307.

Lastly, aluminum is deposited over the electron injection layer 2307 by evaporation using resistance heating so as to have a thickness of 200 nm, thereby forming the second electrode 2308. Thus, the light emitting element of the comparative example 5 is completed. The light emitting element of the comparative example 5 is also sealed and baked in a constant temperature bath at 85°C, and used for measurement.

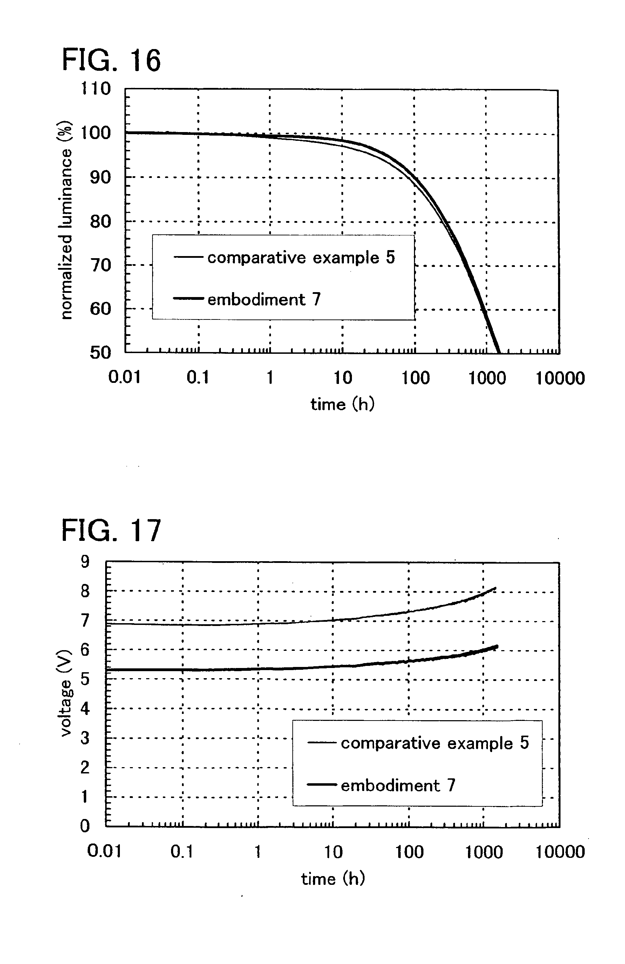

FIG 16 shows normalized time-varying luminance of the light emitting element of Embodiment 7 and the light emitting element of the comparative example 5 at room temperature, whereas FIG 17 shows time-varying voltage of them. The time-varying luminance and the time-varying voltage are measured with an initial luminance of 3000 cd/m² and a constant current flowing.

FIG 16 shows that there is little difference in decrease in luminance over time between the light emitting element of Embodiment 7 and the light emitting element of the comparative example 5. On the other hand, FIG 17 shows that the light emitting element of Embodiment 7 requires a smaller voltage to obtain a constant luminance than the light emitting element of the comparative example 5. FIG. 17 also shows that an increase in voltage over time of the light emitting element of Embodiment 7 is smaller than that of the light emitting element of the comparative example 5. Accordingly, it is found that the light emitting element of the invention has a long life and high reliability.

### [Embodiment 8]

In this embodiment, a specific example of a light emitting element of the invention is described with reference to FIG. 22.

First, indium tin oxide containing silicon oxide is deposited over the glass substrate 2301 by sputtering, thereby forming the first electrode 2302. The first electrode 2302 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2303 is formed over the first electrode 2302 by co-evaporating DNTPD and molybdenum oxide (VI). The layer containing a composite material 2303 has a thickness of 150 nm, and the volume ratio between DNTPD and molybdenum oxide (VI) is adjusted so that molybdenum oxide is contained by 13 vol%.

Then, NPB is deposited over the layer containing a composite material 2303 by evaporation using resistance heating so as to have a thickness of 10 nm, thereby forming the hole transporting layer 2304.

Further, the light emitting layer 2305 with a thickness of 40 nm is formed over the hole transporting layer 2304 by co-evaporating Alq and coumarin 6. Here, the weight ratio between Alq and coumarin 6 is adjusted so as to be 1 : 0.01 (= Alq : coumarin 6).

Then, bathophenanthroline (product of Tokyo Kasei Kogyo Co., Ltd.) is deposited over the light emitting layer 2305 by evaporation using resistance heating so as to have a thickness of 30 nm, thereby forming the electron transporting layer 2306.

Further, lithium fluoride is deposited over the electron transporting layer 2306 so as to have a thickness of 1 nm, thereby forming the electron injection layer 2307.

Lastly, aluminum is deposited over the electron injection layer 2307 by evaporation using resistance heating so as to have a thickness of 200 nm, thereby forming the second electrode 2308. Thus, the light emitting element of Embodiment 8 is completed. After that, the light emitting element is sealed and baked in a constant temperature bath at 85°C, then crystallization of the light emitting element is not observed. This baked light emitting element is used for measurement.

### (Comparative Example 6)

As a comparative light emitting element, a light emitting element having the following structure is manufactured.

First, indium tin oxide containing silicon oxide is deposited over the glass substrate 2301 by sputtering, thereby forming the first electrode 2302. The first electrode 2302 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2303 is formed over the first electrode 2302 by co-evaporating DNTPD and molybdenum oxide (VI). The layer containing a composite material 2303 has a thickness of 150 nm, and the volume ratio between DNTPD and molybdenum oxide (VI) is adjusted so that molybdenum oxide is contained by 13 vol%.

Then, NPB is deposited over the layer containing a composite material 2303 by evaporation using resistance heating so as to have a thickness of 10 nm, thereby forming the hole transporting layer 2304.

Further, the light emitting layer 2305 with a thickness of 40 nm is formed over the hole transporting layer 2304 by co-evaporating Alq and coumarin 6. Here, the weight ratio between Alq and coumarin 6 is adjusted so as to be 1 : 0.01 (= Alq : coumarin 6).

Then, Alq is deposited over the light emitting layer 2305 by evaporation using resistance heating so as to have a thickness of 30 nm, thereby forming the electron transporting layer 2306.

Further, lithium fluoride is deposited over the electron transporting layer 2306 so as to have a thickness of 1 nm, thereby forming the electron injection layer 2307.

Lastly, aluminum is deposited over the electron injection layer 2307 by evaporation using resistance heating so as to have a thickness of 200 nm, thereby forming the second electrode 2308. Thus, the light emitting element of the comparative example 6 is completed. The light emitting element of the comparative example 6 is also sealed and baked in a constant temperature bath at 85°C, and used for measurement.

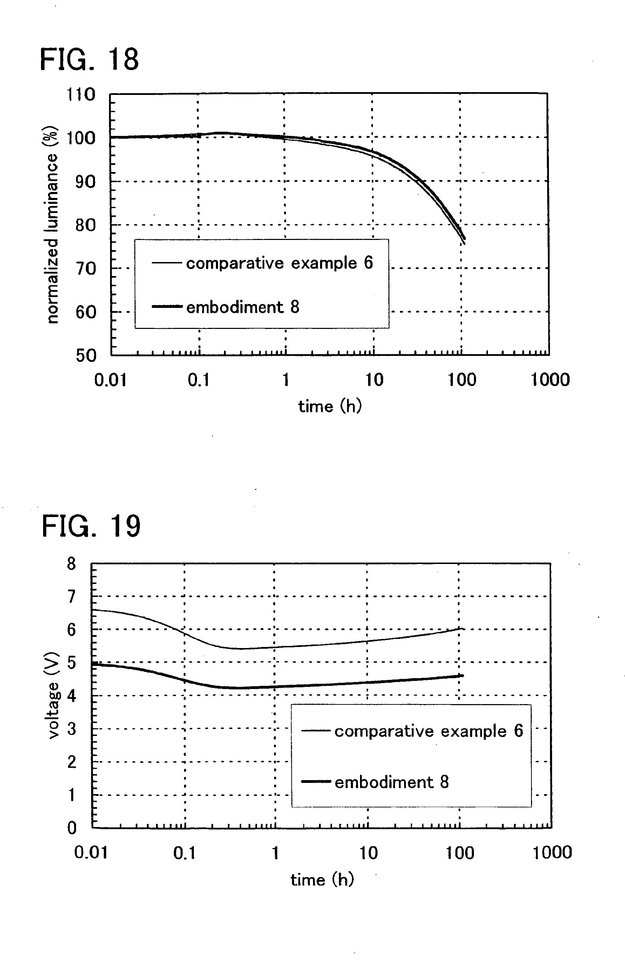

FIG 18 shows normalized time-varying luminance of the light emitting element of Embodiment 8 and the light emitting element of the comparative example 6 at 60°C, whereas FIG. 19 shows time-varying voltage of them. The time-varying luminance and the time-varying voltage are measured with an initial luminance of 3000 cd/m² and a constant current flowing.

FIG 18 shows that there is little difference in decrease in luminance over time between the light emitting element of Embodiment 8 and the light emitting element of the comparative example 6. On the other hand, FIG 19 shows that the light emitting element of Embodiment 8 requires a smaller voltage to obtain a constant luminance than the light emitting element of the comparative example 6. FIG. 19 also shows that an increase in voltage over time of the light emitting element of Embodiment 8 is smaller than that of the light emitting element of the comparative example 6. Accordingly, it is found that the light emitting element of the invention has a long life and high reliability. [Embodiment 9]

In this embodiment, a specific example of a light emitting element of the invention is described with reference to FIG. 22.

First, indium tin oxide containing silicon oxide is deposited over the glass substrate 2301 by sputtering, thereby forming the first electrode 2302. The first electrode 2302 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2303 is formed over the first electrode 2302 by co-evaporating t-BuDNA and molybdenum oxide (VI). The layer containing a composite material 2303 has a thickness of 50 nm, and the volume ratio between t-BuDNA and molybdenum oxide (VI) is adjusted so that molybdenum oxide is contained by 10 vol%.

Then, NPB is deposited over the layer containing a composite material 2303 by evaporation using resistance heating so as to have a thickness of 10 nm, thereby forming the hole transporting layer 2304.

Further, the light emitting layer 2305 with a thickness of 30 nm is formed over the hole transporting layer 2304 by co-evaporating 2,3-bis(4-diphenylaminophenyl)quinoxaline (abbreviation: TPAQn) represented by the structural formula (5) and (acetylacetonate)bis[2,3-bis(4-fluorophenyl)quinoxalinato)iridium(III) (abbreviation: Ir(Fdpq)₂(acac)) represented by the structural formula (4). Here, the weight ratio between TPAQn and Ir(Fdpq)₂(acac) is adjusted so as to be 1 : 0.08 (= TPAQn : Ir(Fdpq)₂(acac)).

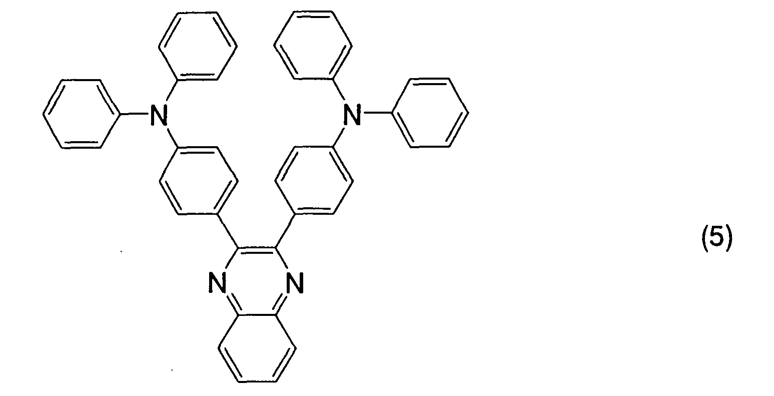

Then, bathophenanthroline (product of Tokyo Kasei Kogyo Co., Ltd.) represented by the structural formula (1) is deposited over the light emitting layer 2305 by evaporation using resistance heating so as to have a thickness of 60 nm, thereby forming the electron transporting layer 2306.

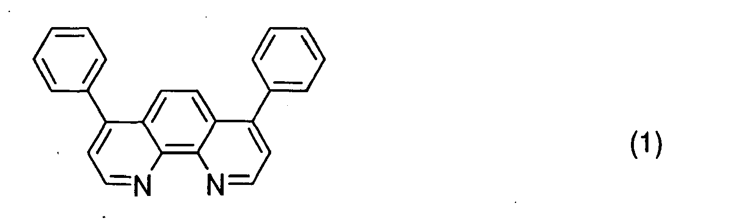

Further, lithium fluoride is deposited over the electron transporting layer 2306 so as to have a thickness of 1 nm, thereby forming the electron injection layer 2307.

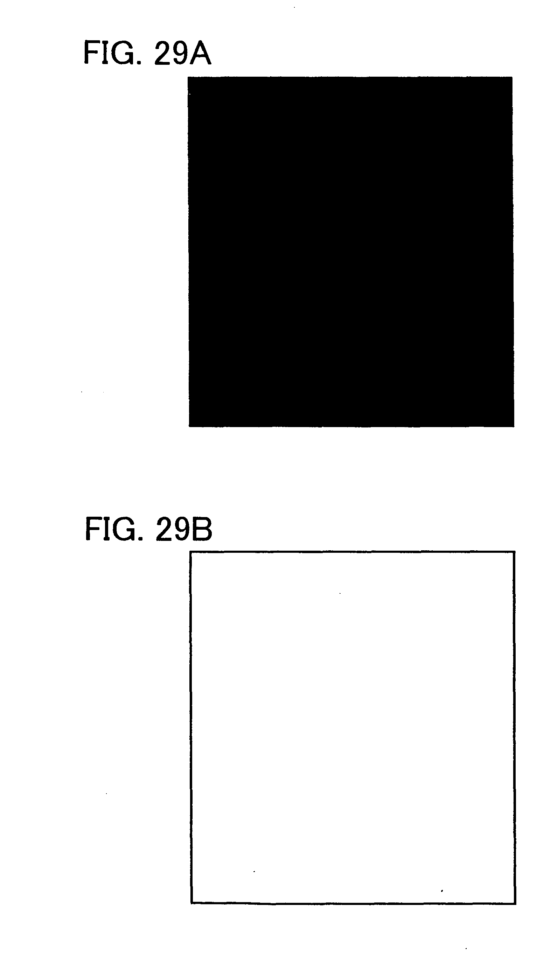

Lastly, aluminum is deposited over the electron injection layer 2307 by evaporation using resistance heating so as to have a thickness of 200 nm, thereby forming the second electrode 2308. Thus, the light emitting element of Embodiment 9 is completed. After that, the light emitting element is sealed and baked in a constant temperature bath at 85°C, then crystallization of the light emitting element is not observed. Even in the microscopic observation performed 73 days later, crystallization is not observed as shown in FIGS. 29A and 29B. FIG. 29A is a photograph of a light emitting element emitting light, which is observed at 50-fold magnification, whereas FIG 29B is a schematic view of the photograph of FIG 29A.

### (Comparative Example 7)

As a comparative light emitting element, a light emitting element having the following structure is manufactured.

First, indium tin oxide containing silicon oxide is deposited over the glass substrate 2301 by sputtering, thereby forming the first electrode 2302. The first electrode 2302 has a thickness of 110 nm and an area of 2 mm × 2 mm.

Next, the substrate where the first electrode is formed is fixed to a substrate holder provided in a vacuum evaporation apparatus so that a surface of the substrate over which the first electrode is formed faces downward. After that, the vacuum apparatus is evacuated to reduce pressure to be about 10⁻⁴ Pa, and the layer containing a composite material 2303 is formed over the first electrode 2302 by co-evaporating t-BuDNA and molybdenum oxide (VI). The layer containing a composite material 2303 has a thickness of 50 nm, and the volume ratio between t-BuDNA and molybdenum oxide (VI) is adjusted so that molybdenum oxide is contained by 10 vol%.

Then, NPB is deposited over the layer containing a composite material 2303 by evaporation using resistance heating so as to have a thickness of 10 nm, thereby forming the hole transporting layer 2304.

Further, the light emitting layer 2305 with a thickness of 30 nm is formed over the hole transporting layer 2304 by co-evaporating TPAQn and Ir(Fdpq)₂(acac). Here, the weight ratio between TPAQn and Ir(Fdpq)₂(acac) is adjusted so as to be 1 : 0.08 (= TPAQn : Ir(Fdpq)₂(acac)).

Then, bathocuproin (abbreviation: BCP) represented by the structural formula (6) is deposited over the light emitting layer 2305 by evaporation using resistance heating so as to have a thickness of 60 nm, thereby forming the electron transporting layer 2306.

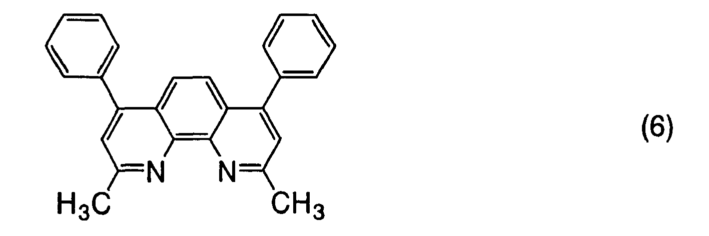

Further, lithium fluoride is deposited over the electron transporting layer 2306 so as to have a thickness of 1 nm, thereby forming the electron injection layer 2307.

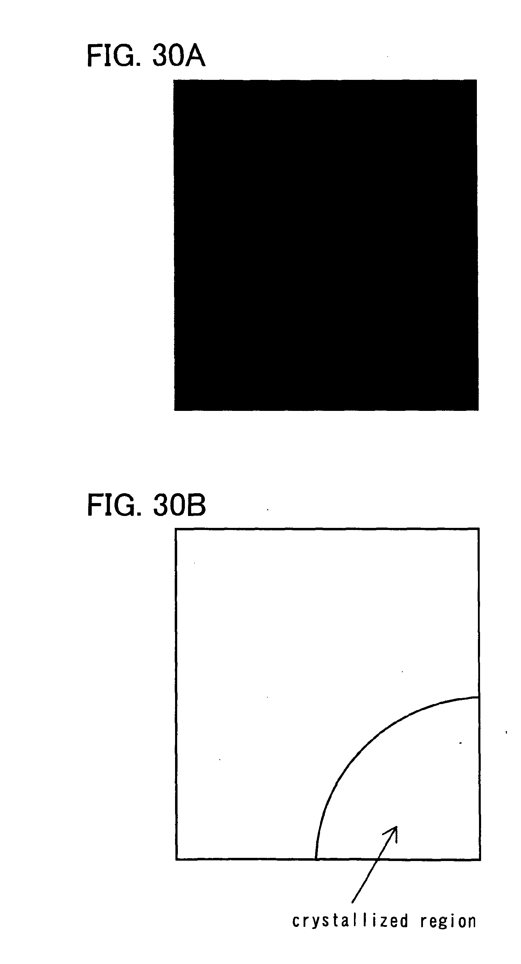

Lastly, aluminum is deposited over the electron injection layer 2307 by evaporation using resistance heating so as to have a thickness of 200 nm, thereby forming the second electrode 2308. Thus, the light emitting element of the comparative example 7 is completed. After that, the light emitting element is sealed and baked in a constant temperature bath at 85°C, then crystallization of the light emitting element is observed. Moreover, in the microscopic observation performed 73 days later, crystallization has progressed as shown in FIGS. 30A and 30B. FIG 30A is a photograph of a light emitting element emitting light, which is observed at 50-fold magnification, whereas FIG 30B is a schematic view of the photograph of FIG 30A.

Bathophenanthroline used for the light emitting element of the invention is not crystallized easily even when the film thickness increases; therefore, a light emitting element with excellent properties can be obtained. [Embodiment 10]

Described in this embodiment is a method for synthesizing 9-(4-{*N*-[4-(9-carbazolyl)phenyl]-*N*-phenylamino}phenyl)-10-phenylanthracene (abbreviation: YGAPA) represented by the structural formula (3), which is used for the light emitting element manufactured in other embodiments.

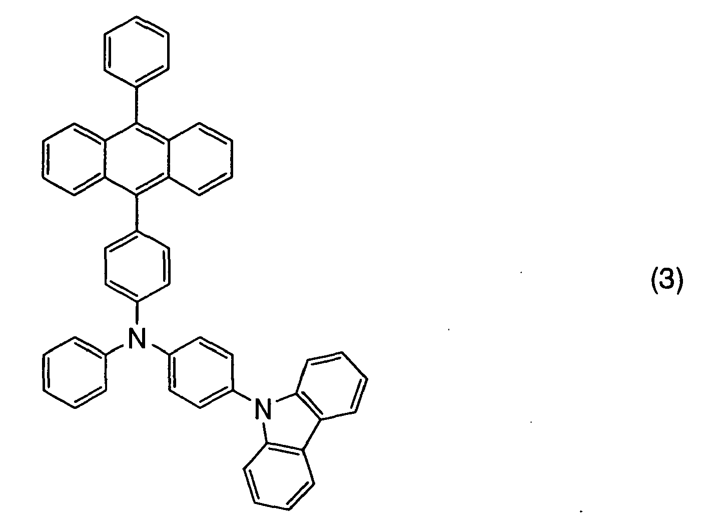

### [Step 1]

A method for synthesizing 9-[4-(*N*-phenylamino)phenyl]carbazole (abbreviation: YGA) is described.

### (i) Synthesis of N-(4-bromophenyl)carbazole

A synthesis scheme (d-1) of *N*-(4-bromophenyl)carbazole is shown below.

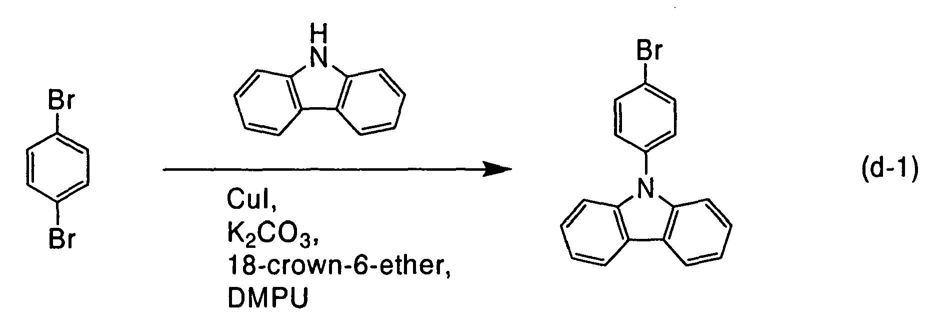

First, a method for synthesizing *N*-(4-bromophenyl)carbazole is described. In a three-necked flask of 300 ml content, 56.3 g (0.24 mol) of 1,4-dibromobenzene, 31.3 g (0.18 mol) of carbazole, 4.6 g (0.024 mol) of copper iodide, 66.3 g (0.48 mol) of potassium carbonate, and 2.1 g (0.008 mol) of 18-crown-6-ether are mixed and substituted by nitrogen. Then, 8 ml of DMPU is added and stirred for 6 hours at 180°C. After the reaction mixture is cooled to room temperature, the sediment is removed by suction filtration. The filtrate is washed with diluted hydrochloric acid, a saturated sodium hydrogen carbonate aqueous solution, and saturated saline in this order and then dried with magnesium sulfate. After the drying, the reaction mixture is naturally filtered and concentrated, and then the obtained oil-like substance is purified by silica gel column chromatography (hexane : ethyl acetate = 9 : 1) and recrystallized with chloroform and hexane. Then, the intended object, which is a light brown plate-like crystal is obtained in an amount of 20.7 g with a yield of 35%.

The ¹H-NMR of the compound is shown below.
The ¹H-NMR (300 MHz, DMSO-d₆) δ ppm : 8.14 (d, δ = 7.8 Hz, 2H), 7.73 (d, δ = 8.7 Hz, 2H), 7.46 (d, δ = 8.4 Hz, 2H), and 7.42 - 7.26 (m, 6H).

### (ii) Synthesis of 9-[4-(N-phenylamino)phenyl]carbazole

A synthesis scheme (d-2) of 9-[4-(*N*-phenylamino)phenyl]carbazole is shown below.

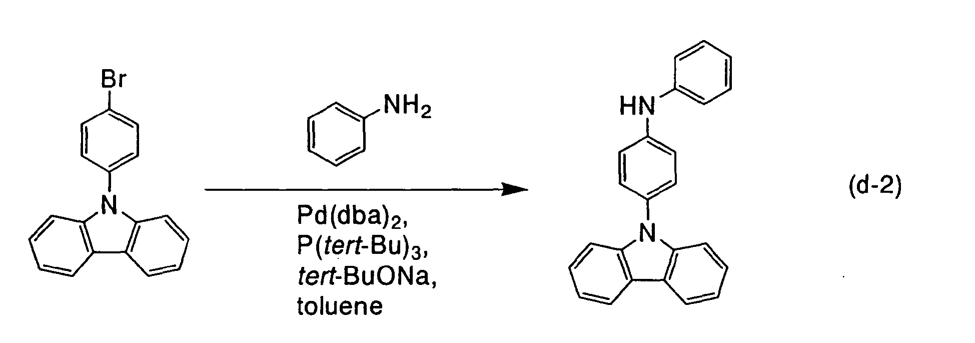

Next, in a three-necked flask of 200 ml content, 5.4 g (17.0 mmol) of N-(4-bromophenyl)carbazole, 1.8 ml (20.0 mmol) of aniline, and 100 mg (0.17 mmol) of bis(dibenzylideneacetone)palladium (0) (abbreviation: Pd(dba)₂), and 3.9 g (40 mmol) of sodium-*tert*-butoxide (abbreviation: tert-BuONa) are mixed and substituted by nitrogen. Then, 0.1 ml of tri-*tert*-butylphosphine (abbreviation: P(tert-Bu)₃) and 50 ml of toluene are added and stirred for 6 hours at 80°C. After the reaction mixture is filtered through Florisil, celite, and alumina and the filtrate is washed with water and saturated saline and then dried with magnesium sulfate. The reaction mixture is naturally filtered and concentrated, and then the obtained oil-like substance is purified by silica gel column chromatography (hexane : ethyl acetate = 9 : 1), thereby the intended object is obtained in an amount of 4.1 g with a yield of 73%. By using a nuclear magnetic resonance spectrometry (NMR), it is confirmed that this compound is 9-[4-(*N*-phenylamino)phenyl]carbazole (abbreviation: YGA).

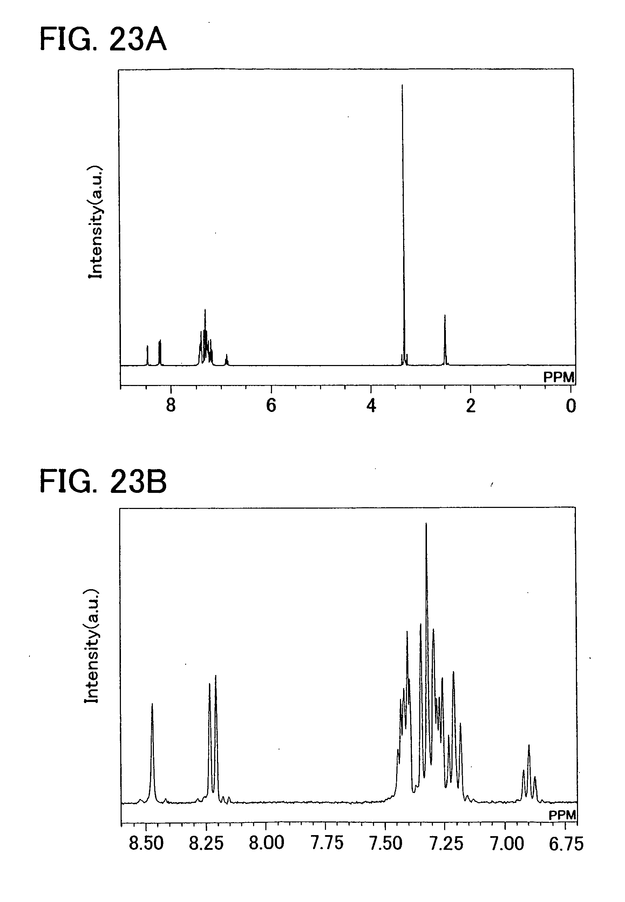

The ¹H-NMR of the compound is shown below. A ¹H-NMR chart is also shown in FIGS. 23A and 23B. Note that FIG. 23B is a chart showing an enlarged part in the range of 6.7 to 8.6 ppm of FIG 23A.

The ¹H-NMR (300 MHz, DMSO-d₆) δ ppm : 8.47 (s, 1H), 8.22 (d, δ = 7.8 Hz, 2H), 7.44 - 7.16 (m, 14H), and 6.92 - 6.87 (m, 1H).

### [Step 2]

A method for synthesizing 9-phenyl-10-(4-bromophenyl)anthracene (abbreviation: PA) is described.

### (i) Synthesis of 9-phenylanthracene

A synthesis scheme (f-1) of 9-phenylanthracene is shown below.

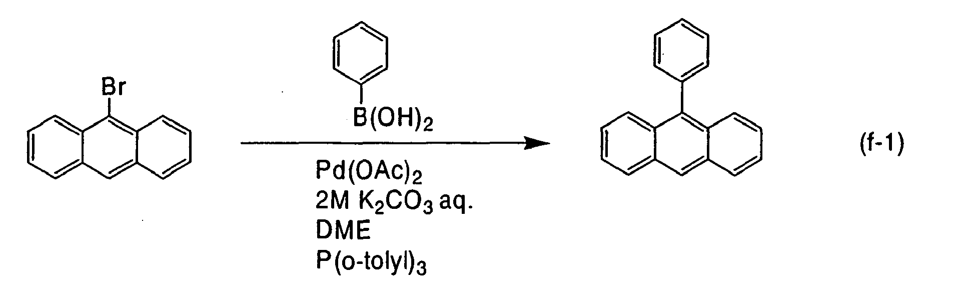

5.4 g (21.1 mmol) of 9-bromoanthracene, 2.6 g (21.1 mmol) of phenylboronic acid, 60 mg (0.21 mmol) of palladium acetate (Pd(OAc)₂), 10mL (20 mmol) of potassium carbonate (K₂CO₃) aqueous solution (2 mol/L), 263 mg (0.84 mmol) of tri(o-tolyl)phosphine (P(o-tolyl)₃), and 20 mL of 1,2-dimethoxyethane (abbreviation: DME) are mixed and stirred for 9 hours at 80°C. After the reaction, the precipitated solid is collected by suction filtration, dissolved in toluene, and filtered through Florisil, celite, and alumina. The filtrate is washed with water and saturated saline and then dried with magnesium sulfate. After naturally filtered and the filtrate is concentrated, the intended object, which is a light brown solid of 9-phenylanthracene is obtained in an amount of 21.5 g with a yield of 85%.

### (ii) Synthesis of 10-bromo-9-phenylanthracene

A synthesis scheme (f-2) of 10-bromo-9-phenylanthracene is described below.

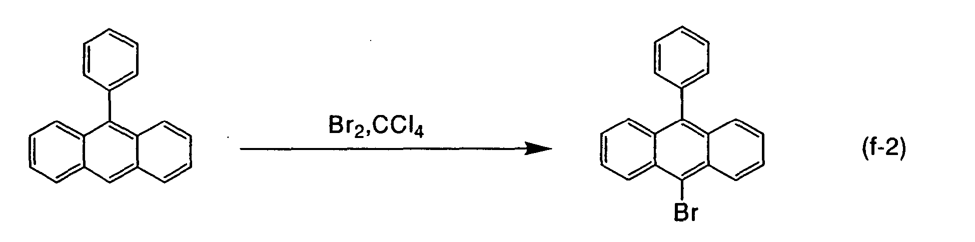

After 6.0 g (23.7 mmol) of 9-phenylanthracene is dissolved in 80 mL of carbon tetrachloride, carbon tetrachloride solution (10 mL) containing 3.80 g (21.1 mmol) of bromine is dropped from a dropping funnel into the reaction solution. After the dropping, the solution is stirred for one hour at room temperature. After the reaction, a sodium thiosulfate aqueous solution is added to stop the reaction. An organic layer is washed with sodium hydroxide (NaOH) aqueous solution and saturated saline, and dried with magnesium sulfate. After naturally filtered, the filtrate is concentrated, dissolved in toluene, and filtered through Florisil, celite, and alumina. When the filtrate is concentrated and recrystallized with dichloromethane and hexane, the intended object, which is a light yellow solid of 10-bromo-9-phenylanthracene is obtained in an amount of 7.0 g at a yield of 89 %.

### (iii) Synthesis of 9-iodo-10-phenylanthracene

A synthesis scheme (f-3) of 9-iodo-10-phenylanthracene is shown below.

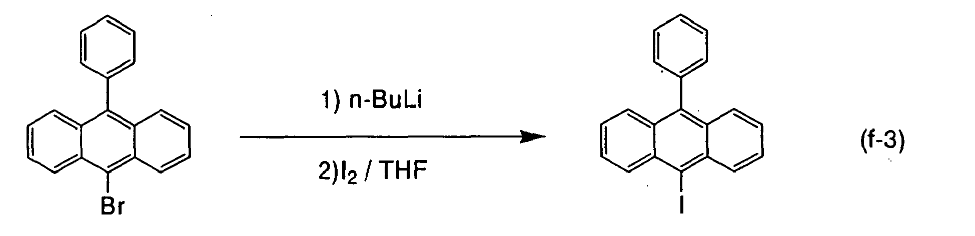

After 3.33 g (10 mmol) of 9-bromo-10-phenylanthracene is dissolved in 80 mL of tetrahydrofuran (abbreviation: THF) and cooled to -78 °C, 7.5 mL (12.0 mmol) of n-BuLi (1.6 mol/L) is dropped from a dropping funnel into the reaction solution and stirred for one hour. Subsequently, 20 mL of THF solution containing 5g (20.0 mmol) of iodine is dropped, and stirred for 2 hours at -78 °C. After the reaction, a sodium thiosulfate aqueous solution is added to stop the reaction. An organic layer is washed with sodium thiosulfate aqueous solution and saturated saline, and dried with magnesium sulfate. After naturally filtered, the filtrate is concentrated and recrystallized with ethanol, thereby the intended object, which is a light yellow solid of 9-iodo-10-phenylanthracene is obtained in an amount of 3.1 g at a yield of 83 %.

### (iv) Synthesis of 9-phenyl-10-(4-bromophenyl)anthracene (abbreviation: PA)

A synthesis scheme (f-4) of 9-phenyl-10-(4-bromophenyl)anthracene (abbreviation: PA) is shown below.

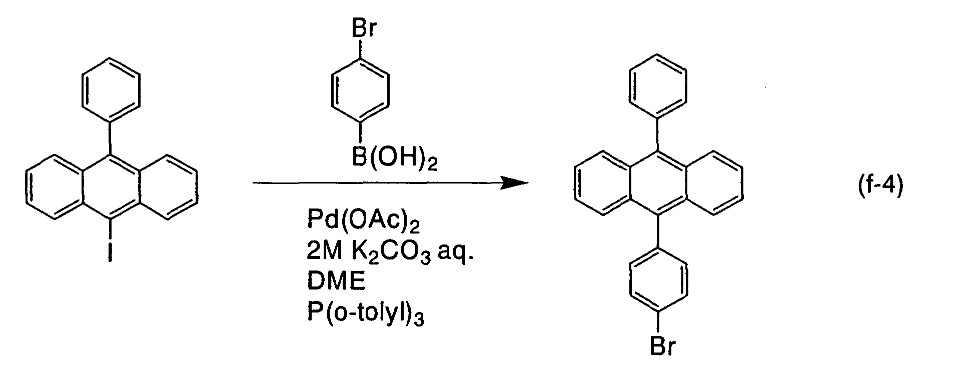

1.0 g (2.63 mmol) of 9-iodo-10-phenylanthracene, 542 mg (2.70 mmol) of p-bromophenylboronic acid, 46 mg (0.03 mmol) of tetrakis(triphenylphosphine)palladium (0) (Pd(PPh₃)₄), 3mL (6 mmol) of potassium carbonate aqueous solution (2 mol/L), and 10 mL of toluene are mixed and stirred for 9 hours at 80°C. After the reaction, toluene is added thereto, and the reaction mixture is filtered through Florisil, celite, and alumina. The filtrate is washed with water and saturated saline and then dried with magnesium sulfate. After naturally filtered, the filtrate is concentrated and recrystallized with chloroform and hexane, thereby the intended object, which is a light brown solid of 9-phenyl-10-(4-bromophenyl)anthracene is obtained in an amount of 562 mg with a yield of 45%.

### [Step 3]

A method for synthesizing 9-(4-{*N*-[4-(9-carbazolyl)phenyl]-*N*-phenylamino}phenyl)-10-phenylanthracene (abbreviation: YGAPA) is described. A synthesis scheme (f-5) of 9-(4-{*N*-[4-(9-carbazolyl)phenyl]-*N*-phenylamino}phenyl)-10-phenylanthracene (abbreviation: YGAPA) is shown below.

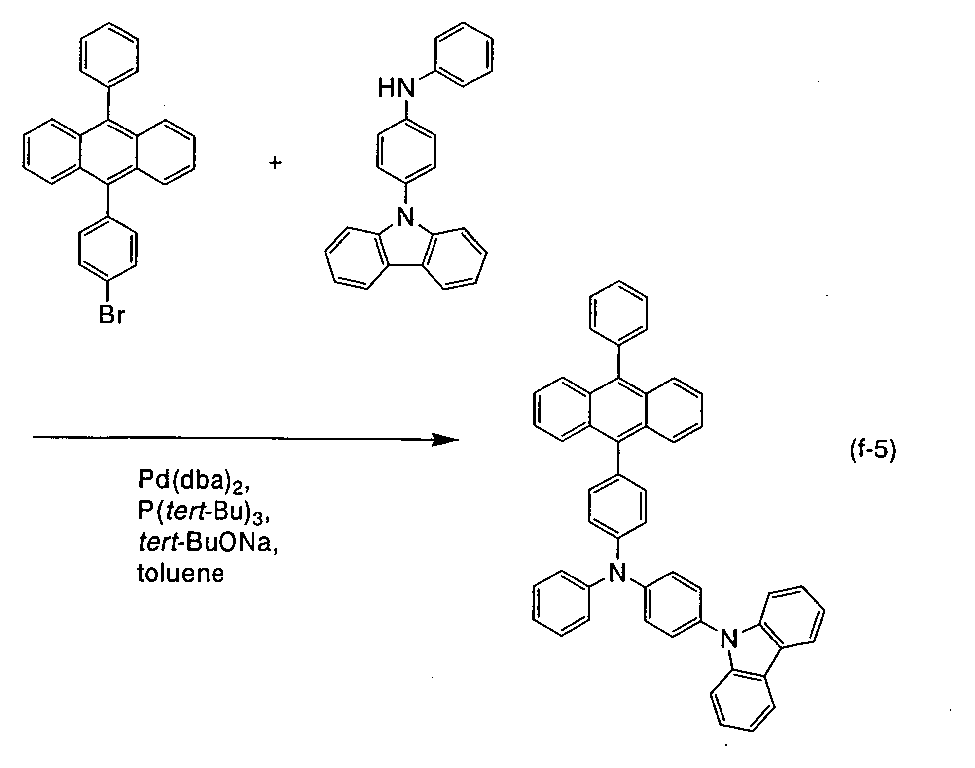

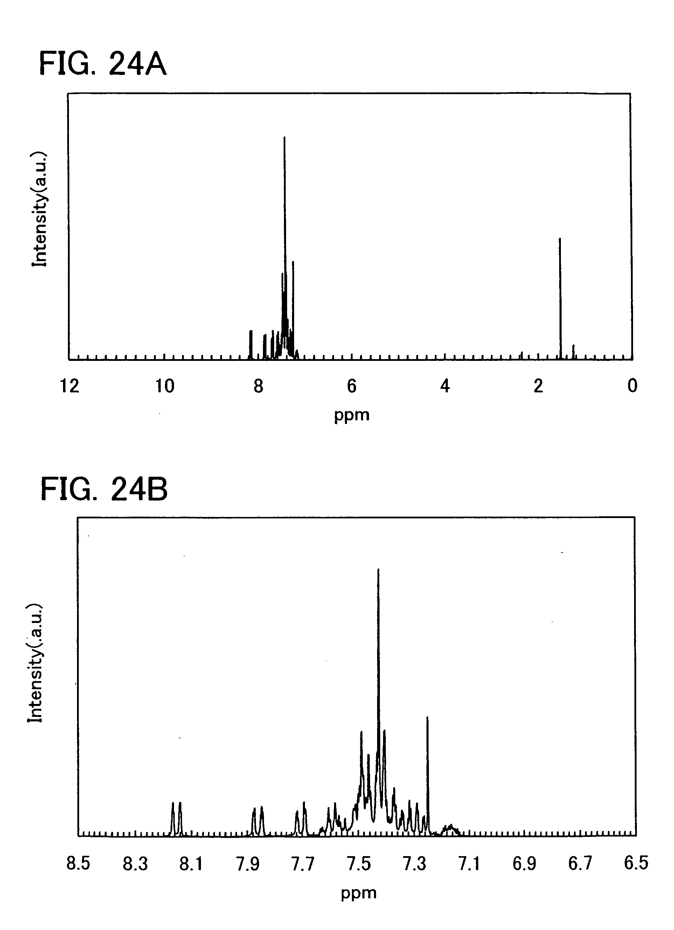

409 mg (1.0 mmol) of 9-phenyl-10-(4-bromophenyl)anthracene, 339 mg (1.0 mmol) of YGA, 6 mg (0.01 mmol) of bis(dibenzylideneacetone)palladium (0) (abbreviation: Pd(dba)₂), 500 mg (5.2 mol) of sodium-*tert*-butoxide (tert-BuONa), 0.1 mL of tri(*tert*-butyl)phosphine (P(tert)-Bu)₃), and 10 mL of toluene are mixed and stirred for four hours at 80°C. After the reaction, the solution is washed with water, a water layer is extracted with toluene, and the water layer as well as an organic layer is washed with saturated saline and then dried with magnesium sulfate. After naturally filtered and concentrated, the obtained oil-like substance is purified by silica gel column chromatography (hexane : toluene = 7 : 3) and recrystallized with dichloromethane and hexane. Then, the intended object, which is a yellow powdered solid of YGAPA is obtained in an amount of 534 g with a yield of 81%. When this compound is measured by a nuclear magnetic resonance spectrometry (NMR), it is confirmed that the compound is 9-(4-{*N*-[4-(9-carbazolyl)phenyl]-*N*-phenylamino}phenyl)-10-phenylanthracene (abbreviation: YGAPA). The ¹H-NMR of YGAPA is shown in FIGS. 24A and 24B.

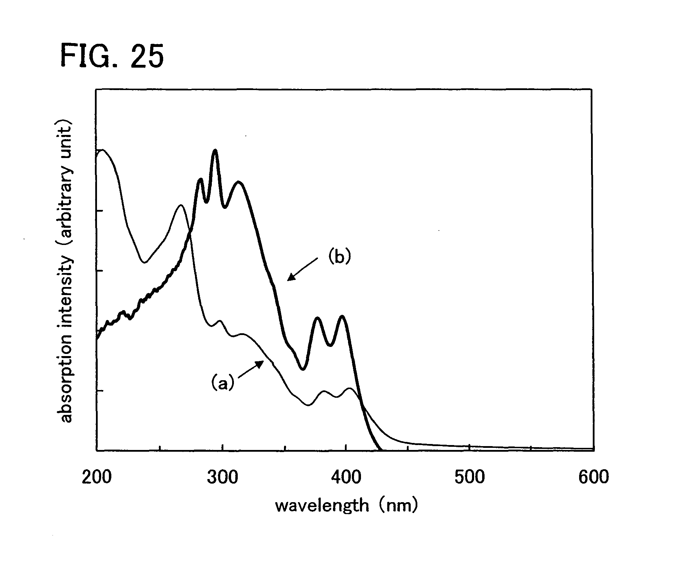

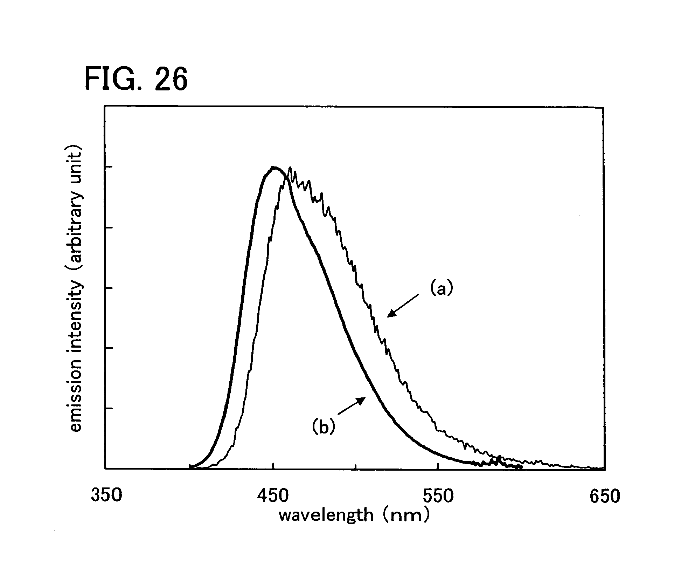

The absorption spectrum of YGAPA is shown in FIG. 25. In FIG 25, the abscissa represents a wavelength (nm) whereas the ordinate represents intensity (arbitrary unit). Further, a line (a) indicates the absorption spectrum in a state where YGAPA is a single film whereas a line (b) indicates the absorption spectrum in a state where YGAPA is dissolved in a toluene solution. The light emission spectrum of YGAPA is shown in FIG 26. In FIG 26, the abscissa represents a wavelength (nm) whereas the ordinate represents light emission intensity (arbitrary unit). A line (a) indicates the light emission spectrum (an excited wavelength: 390 nm) in a state where YGAPA is a single film and a line (b) indicates the light emission spectrum (an excited wavelength: 370 nm) in a state where YGAPA is dissolved in a toluene solution. FIG 26 shows that light emission from the YGAPA has a peak at 461 nm in the single film state and has a peak at 454 nm in the dissolved state in the toluene solution. Moreover, the light emission is recognized as blue light. Thus, it is found that YGAPA is suitable as a light emitting substance which emits blue light.

When YGAPA obtained in this manner is deposited by evaporation and the ionizing potential of YGAPA in the thin film state is measured with a photoelectron spectrometer (AC-2, product of RIKEN KEIKI CO., LTD.), an ionizing potential of 5.55 eV is measured. The absorption spectrum of YGAPA in the thin film state is measured with a UV and visible light spectrophotometer (V-550, product of Japan Spectroscopy Corporation), and the wavelength of an absorption edge at a longer wavelength side of the absorption spectrum is set to be an energy gap (2.95 eV). Under these conditions, a LUMO level of -2.60 eV is measured.

Further, when a decomposition temperature T_{d} of the thus obtained YGAPA is measured with a thermo-gravimetric/differential thermal analyzer (TG/DTA 320, product of Seiko Instruments Inc.), T_{d} is 402°C or more; therefore, it is found that YGAPA has excellent heat resistant properties.

### [Embodiment 11]

Described in this embodiment is a method for synthesizing 9-[4-(*N*-carbazolyl)]phenyl-10-phenylanthracene (abbreviation: CzPA) represented by the structural formula (2), which is used for the light emitting element manufactured in other embodiments.

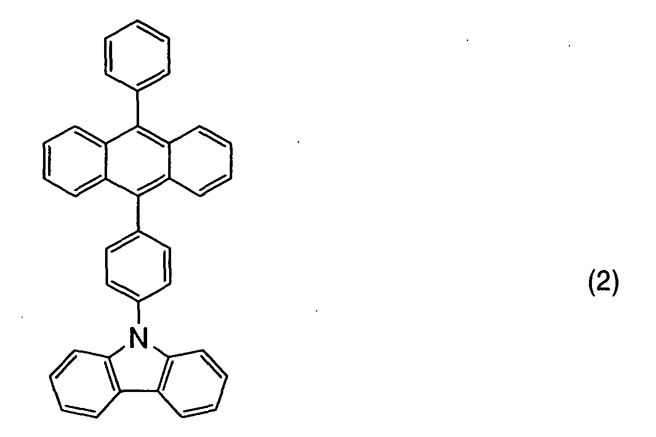

### (i) Synthesis of 9-[4-(N-carbazolyl)]phenyl-10-phenylanthracene (abbreviation: CzPA)

A synthesis scheme (h-1) of 9-[4-(*N*-carbazolyl)]phenyl-10-phenylanthracene (abbreviation: CzPA) is shown below.

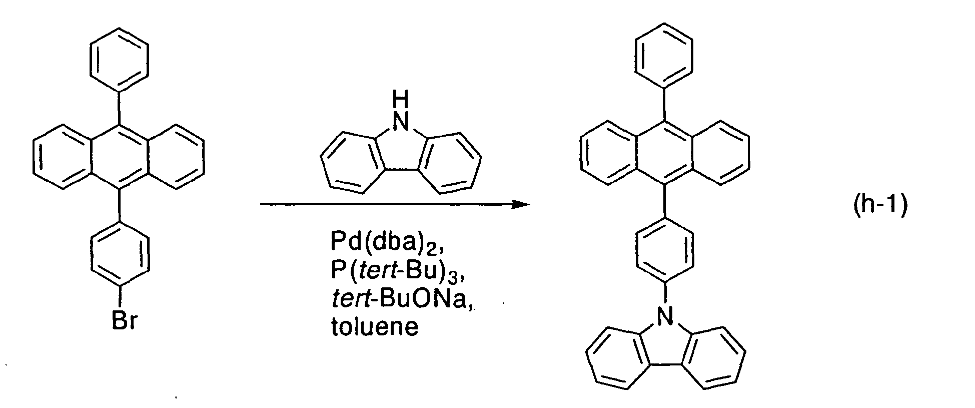

A mixture of 1.3 g (3.2 mmol) of 9-phenyl-10-(4-bromophenyl)anthracene, 578 mg (3.5 mmol) of carbazole, 50 mg (0.017 mmol) of bis(dibenzylideneacetone)palladium (0), 1.0 mg (0.010 mmol) of *t*-butoxysodium, 0.1 mL of tri(*t*-butylphosphine), and 30 mL of toluene is heated and refluxed for 10 hours at 110°C. After the reaction, the solution is washed with water, a water layer is extracted with toluene, and the water layer as well as an organic layer is washed with saturated saline and then dried with magnesium sulfate. After naturally filtered and concentrated, the obtained oil-like substance is purified by silica gel column chromatography (hexane : toluene = 7 : 3) and recrystallized with dichloromethane and hexane. Then, the intended object, which is 9-[4-(*N*-carbazolyl)]phenyl-10-phenylanthracene (abbreviation: CzPA) is obtained in an amount of 1.5 g with a yield of 93%. When 5.50 g of the thus obtained CzPA is sublimed and purified for 20 hours under the conditions of a temperature of 270°C, in argon air (flow rate: 3.0 mL/min), and a pressure of 6.7 Pa, 3.98 g of CzPa is obtained (yield of 72%).

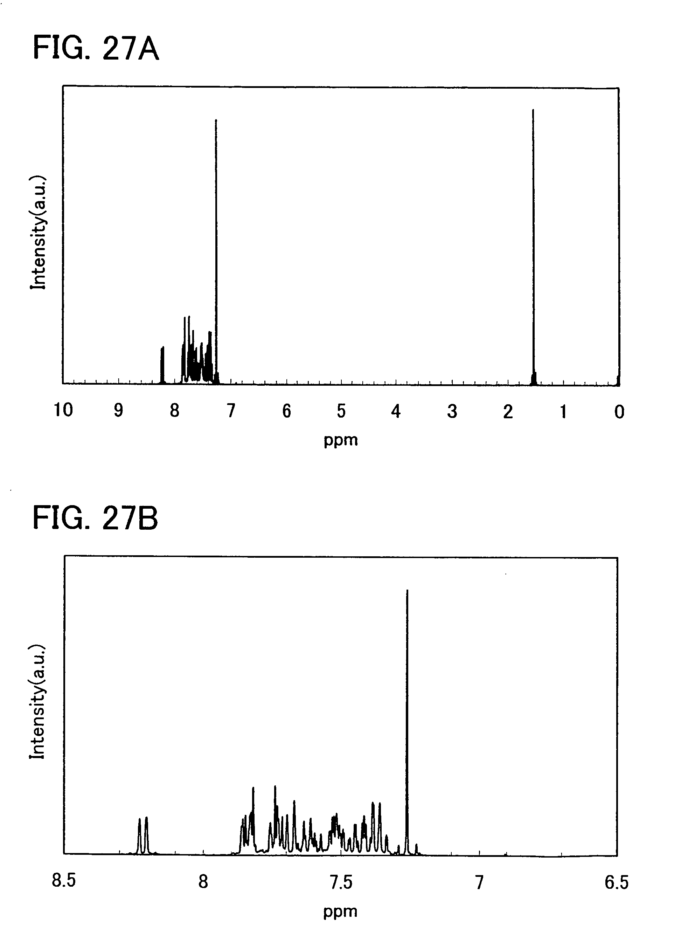

The NMR data of the obtained CzPa is shown below. The ¹H-NMR (300 MHz, CDCl₃); δ = 8.22 (d, J = 7.8 Hz, 2H), 7.86 - 7.82 (m, 3H), and 7.61 - 7.36 (m, 20H). A ¹H-NMR chart is shown in FIGS. 27A and 27B.

CzPA is a light yellow powdered solid. The thermogravimetry-differential thermal analysis (TG-DTA) of CzPA is performed using a thermo-gravimetric/differential thermal analyzer (TG/DTA SCC/5200, product of Seiko Instruments Inc.). The thermophysical properties are evaluated under a nitrogen atmosphere at a rate of temperature rise of 10 °C/min. As a result, based on the relationship between gravity and temperature (thermogravimetric measurement), the decomposing temperature under normal pressure is 348°C that is the temperature at which the gravity is 95 % or less of the gravity at the starting point of the measurement. The glass transition temperature and the melting point of CzPA, which are measured with a differential scanning calorimeter (Pyris 1 DSC, product of Perkin Elmer Co., Ltd.), are 125°C and 305°C respectively; thus, CzPA is proved to be thermally stable.

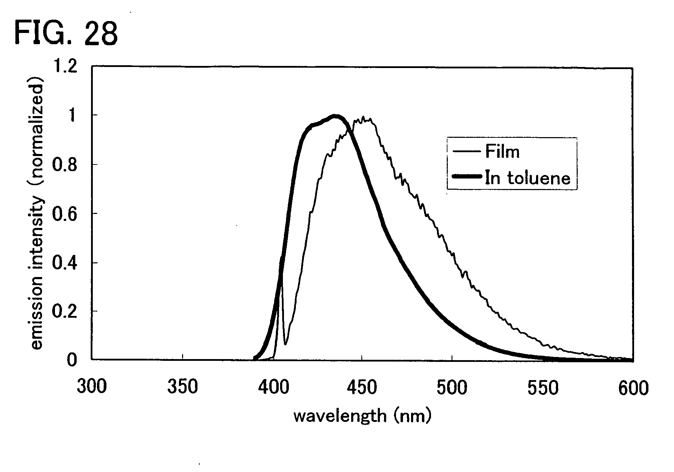

When the absorption spectrum of CzPA in a toluene solution and CzPA in a thin film state is measured, the absorption based on anthracene is observed at about 390 nm and 400 nm, respectively. In addition, FIG 28 shows emission spectrum of the CzPA in a toluene solution and the CzPA in a thin film state. In FIG. 28, the abscissa indicates a wavelength (nm) and the ordinate indicates emission intensity (arbitrary unit). It is found that the maximum emission wavelengths of the CzPA in a toluene solution and the CzPA in a thin film state are 448 nm (excited wavelength: 370 nm) and 451 nm (excited wavelength: 403 nm), respectively, and thus, blue light emission can be obtained.

The HOMO level and the LUMO level of the CzPA in thin film state are measured. The value of the HOMO level is obtained by converting the value of the ionization potential measured with a photoelectron spectroscopy device (AC-2, product of Riken Keiki Co., Ltd.) into a negative value. The value of the LUMO level is obtained by adding the absorption edge of the thin film as an energy gap to the value of the HOMO level. As a result, the HOMO level and the LUMO level are -5.64 eV and -2.71 eV respectively, and an extremely large band gap of 2.93 eV is thus obtained.
This application is based on Japanese Patent Application serial No. 2005-303475 filed in Japan Patent Office on October 18, 2005, the entire contents of which are hereby incorporated by reference.

## Claims

1. A light emitting element comprising:
a first electrode;
a light emitting layer containing a light emitting substance over the first electrode;
a layer containing bathophenanthroline over the light emitting layer containing the light emitting substance; and
a second electrode over the layer containing bathophenanthroline,
wherein the light emitting substance emits light when a voltage is applied so that a potential of the first electrode is higher than a potential of the second electrode, and
wherein a layer containing one or more of lithium fluoride, cesium fluoride, and calcium fluoride is provided between the layer containing bathophenanthroline and the second electrode.

2. The light emitting element according to claim 1, wherein the layer containing bathophenanthroline has a thickness of 10 to 100 nm.

3. The light emitting element according to claim 1, wherein the layer containing bathophenanthroline has a thickness of 30 to 60 nm

4. A light emitting device including the light emitting element according to claim 1 and a control means for controlling light emission of the light emitting element.

5. An electronic apparatus comprising a display portion including the light emitting element according to claim 1 and a control means for controlling light emission of the light emitting element.

6. The light emitting element according to claim 1, wherein an alkali metal or an alkaline earth metal is not doped in the layer containing bathophenanthroline.

7. A light emitting element comprising:
a first electrode;
a layer containing a composite material of an organic compound and an inorganic compound over the first electrode;
a light emitting layer containing a light emitting substance over the layer containing the composite material of the organic compound and the inorganic compound;
a layer containing bathophenanthroline over the light emitting layer containing the light emitting substance; and
a second electrode over the layer containing bathophenanthroline.

8. The light emitting element according to claim 7, wherein a layer containing an alkali metal compound or an alkaline earth metal compound is provided between the layer containing bathophenanthroline and the second electrode.

9. The light emitting element according to claim 8, wherein the layer containing an alkali metal compound or an alkaline earth metal compound is a layer containing one or more of lithium fluoride, cesium fluoride, and calcium fluoride.

10. The light emitting element according to claim 7, wherein the organic compound is an aromatic amine compound.

11. The light emitting element according to claim 7, wherein the organic compound is a carbazole derivative.

12. The light emitting element according to claim 7, wherein the organic compound is aromatic hydrocarbon.

13. The light emitting element according to claim 7, wherein the inorganic compound exhibits electron accepting properties with respect to the organic compound.

14. The light emitting element according to claim 7, wherein the inorganic compound is a transition metal oxide.

15. The light emitting element according to claim 7, wherein the inorganic compound is an oxide of a metal belonging to groups 4 to 8 of the periodic table.

16. The light emitting element according to claim 7, wherein the inorganic compound is any one of vanadium oxide, niobium oxide, tantalum oxide, chromium oxide, molybdenum oxide, tungsten oxide, manganese oxide, and rhenium oxide.

17. The light emitting element according to claim 7, wherein the layer containing bathophenanthroline has a thickness of 10 to 100 nm.

18. The light emitting element according to claim 7, wherein the layer containing bathophenanthroline has a thickness of 30 to 60 nm

19. A light emitting device including the light emitting element according to claim 7 and a control means for controlling light emission of the light emitting element.

20. An electronic apparatus comprising a display portion including the light emitting element according to claim 7 and a control means for controlling light emission of the light emitting element.

21. The light emitting element according to claim 7, wherein an alkali metal or an alkaline earth metal is not doped in the layer containing bathophenanthroline.

22. A light emitting element comprising:
a first electrode;
a layer containing a composite material of an organic compound and an inorganic compound over the first electrode;
a light emitting layer containing a light emitting substance over the layer containing the composite material of the organic compound and the inorganic compound;
a layer containing bathophenanthroline over the light emitting layer containing the light emitting substance; and
a second electrode over the layer containing bathophenanthroline,
wherein the light emitting substance emits light when a voltage is applied so that a potential of the first electrode is higher than a potential of the second electrode.

23. The light emitting element according to claim 22, wherein a layer containing an alkali metal compound or an alkaline earth metal compound is provided between the layer containing bathophenanthroline and the second electrode.

24. The light emitting element according to claim 23, wherein the layer containing an alkali metal compound or an alkaline earth metal compound is a layer containing one or more of lithium fluoride, cesium fluoride, and calcium fluoride.

25. The light emitting element according to claim 22, wherein the organic compound is an aromatic amine compound.

26. The light emitting element according to claim 22, wherein the organic compound is a carbazole derivative.

27. The light emitting element according to claim 22, wherein the organic compound is aromatic hydrocarbon.

28. The light emitting element according to claim 22, wherein the inorganic compound exhibits electron accepting properties with respect to the organic compound.

29. The light emitting element according to claim 22, wherein the inorganic compound is a transition metal oxide.

30. The light emitting element according to claim 22, wherein the inorganic compound is an oxide of a metal belonging to groups 4 to 8 of the periodic table.

31. The light emitting element according to claim 22, wherein the inorganic compound is any one of vanadium oxide, niobium oxide, tantalum oxide, chromium oxide, molybdenum oxide, tungsten oxide, manganese oxide, and rhenium oxide.

32. The light emitting element according to claim 22, wherein the layer containing bathophenanthroline has a thickness of 10 to 100 nm.

33. The light emitting element according to claim 22, wherein the layer containing bathophenanthroline has a thickness of 30 to 60 nm

34. A light emitting device including the light emitting element according to claim 22 and a control means for controlling light emission of the light emitting element.

35. An electronic apparatus comprising a display portion including the light emitting element according to claim 22 and a control means for controlling light emission of the light emitting element.

36. The light emitting element according to claim 22, wherein an alkali metal or an alkaline earth metal is not doped in the layer containing bathophenanthroline.

37. A light emitting element comprising:
a first electrode;
a light emitting layer containing a light emitting substance over the first electrode;
a layer containing bathophenanthroline over the light emitting layer containing the light emitting substance; and
a second electrode over the layer containing bathophenanthroline,
wherein the light emitting substance emits light when a voltage is applied so that a potential of the first electrode is higher than a potential of the second electrode, and
wherein an alkali metal or an alkaline earth metal is not doped in the layer containing bathophenanthroline.

38. The light emitting element according to claim 37, wherein the layer containing bathophenanthroline has a thickness of 10 to 100 nm.

39. The light emitting element according to claim 37, wherein the layer containing bathophenanthroline has a thickness of 30 to 60 nm

40. A light emitting device including the light emitting element according to claim 37 and a control means for controlling light emission of the light emitting element.

41. An electronic apparatus comprising a display portion including the light emitting element according to claim 37 and a control means for controlling light emission of the light emitting element.
